# FASCICULE DE BREVET EUROPEEN

(11) **EP 2 661 413 B1**
(45) Date de publication et mention de la délivrance du brevet: **02.09.2015**
(21) Numéro de dépôt: 12700322.6
(22) Date de dépôt: 02.01.2012
(51) Int. Cl.: B81C 1/00, B81B 7/00

(54) **PROCEDE D'ENCAPSULATION D'UN MICROCOMPOSANT**
VERFAHREN ZUM EINKAPSELN EINER MIKROKOMPONENTE
METHOD FOR ENCAPSULATING A MICRO-COMPONENT

(30) Priorité: 04.01.2011 FR 1150046; 04.01.2011 FR 1150047
(43) Date de publication de la demande: 13.11.2013
(73) Titulaire: Commissariat à l'Énergie Atomique et aux Énergies Alternatives, 75015 Paris (FR)
(72) Inventeur: JACQUET, Fabrice, F-38220 Saint-Pierre-de-Mésage (FR); HENRY, David, 38610 Gieres (FR)
(74) Mandataire: Ahner, Philippe
(86) Numéro de dépôt international: PCT/EP2012/050023
(87) Numéro de publication internationale: WO 2012/093105

(56) Documents cités:
- WO-A2-2007/057814
- WO-A2-2009/134838
- US-A1- 2007 298 532
- US-A1- 2008 290 494

## Description

### DOMAINE TECHNIQUE

L'invention concerne le domaine de l'encapsulation, ou « packaging », de microcomposants.

Le terme « microcomposant » désigne ici tout microsystème de type MEMS (microsystème électromécanique), NEMS (nanosystème électromécanique), MOEMS (microsystème opto-électromécanique), biopuces, ainsi que tout type de composant électronique, optique, ou optoélectronique.

L'invention se rapporte également au domaine des dispositifs électroniques 3D (en trois dimensions), c'est-à-dire comprenant plusieurs composants électroniques empilés, et dans lesquels se posent des problèmes d'échauffement. De tels dispositifs électroniques 3D sont par exemple des microprocesseurs parallèles et/ou associés à des composants sensibles thermiquement tels que des mémoires ou des imageurs, des dispositifs de puissance impliquant de fortes tensions et/ou intensités de courants, ou encore des dispositifs comprenant des composants de type MEMS à forte tension d'actionnement.

### ÉTAT DE LA TECHNIQUE ANTÉRIEURE

L'encapsulation d'un microcomposant consiste généralement à enfermer le microcomposant dans une cavité délimitée par un capot et par le substrat sur lequel le microcomposant est réalisé. Cette cavité est généralement fermée hermétiquement. Cette encapsulation permet de protéger mécaniquement le microcomposant, par exemple lors de la mise en oeuvre d'étapes telles que la découpe du substrat ou le surmoulage (mise en boîtier du microcomposant). Cette encapsulation permet également de contrôler l'atmosphère régnant à l'intérieur de la cavité en y introduisant par exemple un gaz neutre qui évite toute réaction chimique avec le microcomposant, ou en faisant le vide dans la cavité.

Une première solution pour encapsuler des microcomposants consiste à réaliser un report de capots, usinés par exemple dans une plaque de silicium, sur le substrat comportant les microcomposants. Ces capots sont soit collés, soit brasés à l'échelle du substrat. Les microcomposants ainsi encapsulés sont ensuite séparés les uns des autres par une découpe du substrat, formant des puces individuelles assemblées ensuite sur des circuits électroniques.

Ce type d'encapsulation par report de capots présente toutefois plusieurs inconvénients : perte de surface sur le substrat due à la zone de collage ou soudure nécessaire pour solidariser les capots au substrat, complexité du procédé de report mis en oeuvre, etc.

Une solution alternative au report de capots consiste à réaliser un packaging couche mince (PCM) des microcomposants, comme décrit par exemple dans le document EP 1 101 730 A2. Dans cette solution, chaque microcomposant est tout d'abord recouvert par un matériau sacrificiel qui est gravé afin de former une portion de matériau sacrificiel dont le volume correspond à celui de la cavité dans laquelle le microcomposant est destiné à être encapsulé. On réalise ensuite un dépôt d'une couche mince sur le matériau sacrificiel. Le matériau sacrificiel est ensuite gravé via une ouverture formée à travers la couche mince, formant ainsi une cavité dans laquelle le microcomposant est encapsulé et qui est délimitée par le capot, c'est-à-dire la couche mince.

La réalisation d'un PCM est parfaitement adaptée à l'encapsulation de capteurs de type MEMS et permet de protéger les parties sensibles de ces capteurs des agressions mécaniques liées aux étapes ultérieures de découpe, de manipulation, etc.

Le PCM n'est par contre pas adapté à la mise en oeuvre ultérieure d'une étape de surmoulage qui consiste généralement à injecter directement sur le capot un polymère pour former une couche de surmoulage.

Une telle étape de surmoulage implique des contraintes thermomécaniques de l'ordre de 10 x 10³ kPa à 20 x 10³ kPa (100 à 200 bars) et de 150°C à 200°C pendant quelques dizaines de secondes, voir quelques minutes, sur les microcomposants encapsulés. De telles contraintes thermomécaniques peuvent générer des fissures dans les capots PCM, rendant les microcomposants encapsulés inutilisables. Or, cette étape de surmoulage est très importante dans la fabrication des microcomposants car elle permet de fournir le microcomposant sous la forme d'une puce, formant un produit fini, protégé de l'environnement extérieur et prêt à être intégré par des moyens automatiques à grand débit sur les circuits imprimés par exemple.

Le document FR 2 901 264 A1 décrit la réalisation d'un capot comportant une membrane renforcée par des moyens de renfort mécanique réalisés en structurant une paroi sommitale de la membrane, le capot définissant la cavité dans laquelle le microcomposant est encapsulé.

Un tel renfort mécanique du capot n'est toutefois pas suffisant pour que celui-ci puisse supporter des pressions supérieures ou égales à environ 10 x 10³ kPa (100 bars) qui correspondent aux pressions rencontrées lors de la mise en oeuvre d'une étape de surmoulage du microcomposant encapsulé.

Le document WO 2004/077523 A2 décrit un renforcement mécaniquement du capot par un ou plusieurs dépôts de matériaux très durs par pulvérisation sous vide sur le capot, formant des couches pleine plaque de plusieurs micromètres d'épaisseur recouvrant l'ensemble du substrat, ces couches devant être ensuite gravées pour former des surcouches de renfort mécanique recouvrant le capot.

La mise en oeuvre d'un tel procédé présente toutefois plusieurs inconvénients: risques de craquèlement du capot dû au stress (c'est-à-dire des contraintes mécaniques) induit par les dépôts de matériaux de renforcement mécanique, déformation du substrat sur lequel est formé le microcomposant, etc.

De plus, la gravure des couches réalisée est problématique car le type de matériaux pouvant être utilisé est limité aux matériaux pouvant subir une telle gravure. Enfin, le temps de mise en oeuvre d'une telle gravure peut être important.

De plus, ces différentes solutions pour renforcer le capot induisent toutes un coût supplémentaire important par rapport à celui de la réalisation du microsystème.

Le document WO 2007/057814 A2 décrit un procédé d'encapsulation d'un microcomposant dans lequel un microcomposant est recouvert d'une couche sacrificielle. Des contacts électriques sont ensuite réalisés au-dessus de la couche sacrificielle. Une poignée temporaire de verre est ensuite solidarisée au-dessus des contacts électriques afin de supprimer la couche sacrificielle depuis la face arrière du substrat. Ce procédé nécessite d'avoir accès aux deux faces du composant, l'une servant à réaliser les étages de connexions électriques et l'autre servant à la libération du microcomposant. De plus, ce procédé nécessite d'ajouter une poignée temporaire puis de la supprimer.

### EXPOSÉ DE L'INVENTION

Un but de la présente invention est de proposer un procédé d'encapsulation d'un microcomposant ne présentant pas les problèmes des procédés d'encapsulation de l'art antérieur, permettant notamment d'obtenir une structure d'encapsulation ne présentant pas les problèmes de fragilité rencontrés avec une encapsulation de type PCM lors de la mise en oeuvre d'étapes ultérieures de manipulation du microcomposant (également appelées opérations de back-end) telles qu'un surmoulage ou une découpe du substrat, et cela sans nécessiter d'étapes lithographiques supplémentaires par rapport à la réalisation d'un packaging en couche mince standard ni faire appel nécessairement à une poignée temporaire.

Pour cela, la présente invention propose un procédé d'encapsulation d'au moins un microcomposant disposé sur une première face d'un substrat et/ou dans le substrat, comportant au moins les étapes de :
a) réalisation d'au moins un plot de contact électrique sur la première face du substrat,
b) réalisation d'au moins une portion de matériau sacrificiel recouvrant au moins le microcomposant et au moins une partie du plot de contact électrique,
c) réalisation d'au moins une couche épaisse d'encapsulation recouvrant la portion de matériau sacrificiel et au moins une partie de la première face du substrat,
d) réalisation, à travers une seconde face, opposée à la première face, du substrat, d'au moins un premier trou aligné au moins partiellement avec le plot de contact électrique et débouchant au niveau de la portion de matériau sacrificiel,
e) suppression de la portion de matériau sacrificiel à travers le premier trou,
f) réalisation, au moins dans le premier trou, d'au moins une portion de matériau électriquement conducteur reliée électriquement au plot de contact électrique, formant un premier via conducteur.

Il est également proposé un procédé d'encapsulation d'au moins un microcomposant disposé sur une première face d'un substrat et/ou dans le substrat, comportant au moins les étapes de :
a) réalisation d'au moins un plot de contact électrique sur la première face du substrat,
b) réalisation d'au moins une portion de matériau sacrificiel recouvrant au moins le microcomposant,
c) réalisation d'au moins une couche épaisse d'encapsulation recouvrant la portion de matériau sacrificiel et d'au moins une partie de la première face du substrat,
d) réalisation, à travers une seconde face, opposée à la première face, du substrat, d'au moins un trou, ou via, de connexion aligné au moins partiellement avec le plot de contact électrique et d'au moins un trou, ou via, de libération débouchant au niveau de la portion de matériau sacrificiel,
e) suppression de la portion de matériau sacrificiel à travers le trou de libération,
f) réalisation, au moins dans le trou de connexion, d'au moins une portion de matériau électriquement conducteur reliée électriquement au plot de contact électrique.

L'expression « couche épaisse » désigne ici une couche de matériau d'épaisseur supérieure ou égale à environ 100 µm, par exemple une couche à base d'un composé d'epoxy surmoulé.

Ainsi, les opérations de back-end, telles qu'une découpe du substrat ou le surmoulage (ou mise en boîtier) du microcomposant, sont mises en oeuvre au niveau du substrat, par exemple de manière collective pour plusieurs microcomposants réalisés sur le substrat, alors que le matériau sacrificiel recouvrant le microcomposant est encore présent. Le matériau sacrificiel recouvrant le microcomposant n'est retiré qu'après la mise en oeuvre de ces étapes back-end.

L'invention permet de réaliser la connexion du microcomposant et la libération de la structure par la face arrière à travers un même trou.

Selon l'invention, l'encapsulation du microcomposant peut donc être réalisée directement par la couche épaisse d'encapsulation, qui forme la couche de surmoulage, recouvrant la portion de matériau sacrificiel. Il n'est donc pas nécessaire de réaliser un capot préalablement au surmoulage du microcomposant.

Le composant obtenu, correspondant à une puce comprenant le microcomposant et obtenue après une découpe du substrat, peut être directement utilisable pour réaliser par exemple un report du composant sur une carte électronique ou un circuit imprimé.

De plus, contrairement à une encapsulation par report d'un capot, le procédé d'encapsulation selon l'invention n'engendre pas de perte de surface sur le substrat.

Le procédé peut comporter en outre, après l'étape e) de suppression de la portion de matériau sacrificiel, une étape de bouchage du premier trou.

La portion de matériau sacrificiel recouvre au moins une partie du plot de contact électrique, et le trou de connexion est confondu avec le trou de libération.

Le premier trou, ou via, permettant de supprimer la portion de matériau sacrificiel, sert également de via de contact électrique afin de former un accès électrique depuis la face arrière du substrat au plot de contact électrique, cet accès ayant précédemment servi à supprimer le matériau sacrificiel afin de libérer le microcomposant.

Dans ce cas, le procédé peut comporter en outre, lorsque la portion de matériau électriquement conducteur reliée électriquement au plot de contact électrique ne bouche pas le premier trou, un dépôt sur et/ou dans le premier trou d'un matériau diélectrique bouchant le premier trou.

Le plot de contact électrique peut comporter au moins une portion de matériau électriquement conducteur entourant au moins un espace vide, le premier trou pouvant être aligné avec l'espace vide.

La portion de matériau électriquement conducteur peut avoir, dans un plan parallèle à la première face du substrat, une forme d'anneau.

L'étape c) peut être obtenue par le dépôt d'une résine de type polymère formant la couche épaisse d'encapsulation. Ainsi, la couche épaisse d'encapsulation est à base d'un produit de surmoulage pouvant être déposé par injection sur la portion de matériau sacrificiel sans dégrader le microcomposant.

Dans une variante, l'étape c) peut être obtenue :
- en découpant une portion du substrat contre laquelle sont disposés le microcomposant, le plot de contact électrique et la portion de matériau sacrificiel, puis
- en disposant ladite portion du substrat, le microcomposant, le plot de contact électrique et la portion de matériau sacrificiel dans un emplacement formé dans au moins un second substrat formant la couche épaisse d'encapsulation.

Le procédé d'encapsulation peut comporter en outre la mise en oeuvre, après l'étape c), c'est-à-dire après l'une des étapes c), d) ou e), d'un amincissement du substrat au niveau de sa seconde face.

Le procédé d'encapsulation peut comporter en outre la mise en oeuvre, après l'étape c), c'est-à-dire après l'une des étapes c), d), e) ou f), d'une étape de solidarisation de la couche épaisse d'encapsulation à au moins un second substrat. Ainsi, ce second substrat peut former temporairement une poignée mécanique permettant d'améliorer la tenue mécanique de l'ensemble réalisé. L'usage d'une telle poignée mécanique temporaire pourra être avantageux lorsque le substrat est aminci et/ou lorsque la couche épaisse d'encapsulation n'offre pas une tenue mécanique suffisante vis-à-vis des autres éléments.

Le procédé d'encapsulation peut comporter en outre la mise en oeuvre, entre les étapes b) et c), d'une étape de dépôt d'au moins une couche intermédiaire à base d'au moins un matériau minéral diélectrique et/ou d'au moins un matériau électriquement conducteur recouvrant la portion de matériau sacrificiel, la couche épaisse d'encapsulation recouvrant au moins la couche intermédiaire.

La ou les couches intermédiaires ainsi disposées entre la portion de matériau sacrificiel et la couche épaisse d'encapsulation protègent ainsi le microcomposant en formant une partie de la structure d'encapsulation du microcomposant. De plus, en choisissant des matériaux appropriés pour cette ou ces couches intermédiaires, celles-ci peuvent améliorer la sélectivité de gravure de la portion de matériau sacrificiel lors de la mise en oeuvre de l'étape d) étant donné que l'agent de gravure destiné à être utilisé se trouve confronté aux matériaux de ces couches intermédiaires qui peuvent présenter une meilleure sélectivité de gravure que le matériau de la couche épaisse d'encapsulation.

La couche intermédiaire électriquement conductrice disposée entre la couche épaisse d'encapsulation et la portion de matériau sacrificiel peut également remplir d'autres fonctions telles qu'un bouclier électromagnétique, un élément d'un interrupteur, un élément getter absorbant et/ou adsorbant les gaz présents dans la cavité après la gravure de la portion de matériau sacrificiel.

De plus, en disposant une telle couche intermédiaire de protection entre la portion de matériau sacrificiel et la couche épaisse d'encapsulation, il est donc possible de réaliser une encapsulation sous vide ou sous atmosphère contrôlée du microcomposant.

Lorsque la portion de matériau sacrificiel est recouverte par la couche intermédiaire à base du matériau électriquement conducteur, au moins une portion de matériau électriquement conducteur peut être disposée sur la seconde face du substrat et reliée électriquement à la couche intermédiaire à travers au moins un deuxième trou réalisé à travers la seconde face du substrat et débouchant au niveau de la couche intermédiaire.

Le procédé d'encapsulation peut comporter en outre la mise en oeuvre, avant l'étape c), c'est-à-dire avant l'une des étapes a), b) ou c), d'une étape de réalisation de chemins de découpe dans le substrat, et, après l'étape c), c'est-à-dire après l'une des étapes c), d), e) ou f), d'une étape de découpe du substrat selon les chemins de découpe. Ces chemins de découpe peuvent permettre de délimiter les différentes puces réalisées sur le substrat.

Le procédé d'encapsulation peut comporter en outre la réalisation d'au moins un via conducteur supplémentaire, par exemple appelé deuxième via conducteur, par la mise en oeuvre des étapes suivantes :
- réalisation d'au moins un trou supplémentaire, par exemple appelé troisième trou, à travers le substrat,
- réalisation, dans ledit trou supplémentaire, d'au moins une portion de matériau électriquement conducteur s'étendant dans ledit trou supplémentaire à travers le substrat telle qu'au moins un espace vide restant dudit trou supplémentaire s'étendant à travers le substrat est apte à former une zone de circulation d'un fluide.

En réalisant un tel via conducteur supplémentaire dans un composant électronique, on obtient un composant dont la structure permet une évacuation efficace de la chaleur, tout en améliorant le gain de surface globale du composant, et donc la densité d'intégration du composant électronique, en raison du double rôle de conduction électrique et de dissipation thermique rempli par ce ou ces vias conducteurs supplémentaires.

En effet, l'espace vide formé au sein même du via conducteur permet de faire circuler un fluide caloporteur dans et/ou à travers le composant, évitant ainsi la formation et le maintien de points chauds dans le composant électronique, et uniformisant la température dans le composant électronique.

Dans un tel composant électronique, le via conducteur remplit donc à la fois une fonction de conduction électrique grâce à la portion de matériau électriquement conducteur pouvant servir à la transmission de signaux d'une extrémité à l'autre du composant (par exemple une transmission de signaux entre les faces avant et arrière du composant électronique), mais également une fonction de dissipation thermique grâce à l'espace vide permettant la circulation d'un fluide caloporteur afin d'évacuer la chaleur en dehors du composant électronique.

De plus, une telle structure de via conducteur n'impose aucune contrainte sur les dimensions du via conducteur.

Une telle structure de composant électronique permet également de réduire l'encombrement lié à la fonction de dissipation thermique par rapport à un composant faisant appel à une structure dédiée uniquement à la dissipation thermique. Un tel gain de surface du composant se traduit donc par un gain en termes de coût du composant.

De plus, en combinant les fonctions de conduction électrique et de dissipation thermique au sein du via conducteur, on améliore la dissipation thermique réalisée grâce à la plus grande proximité entre la zone de circulation de fluide et la ou les sources chaudes du composant électronique lorsqu'elles se trouvent à proximité des vias conducteurs.

La portion de matériau électriquement conducteur du premier via conducteur peut être telle qu'au moins un espace vide restant du premier trou s'étendant à travers le substrat soit apte à former une zone de circulation d'un fluide. Ainsi, outre les fonctions de conduction électrique et de libération du microcomposant, le premier via conducteur peut donc également servir de via de dissipation thermique grâce à l'espace vide présent dans le via conducteur.

Le matériau électriquement conducteur du premier et/ou du via conducteur supplémentaire peut avoir un coefficient de conductivité thermique supérieur à environ 50 W.m⁻¹.K⁻¹. Ainsi, le matériau électriquement conducteur du via contribue également à dissiper la chaleur au sein du composant étant donné que le fluide caloporteur est destiné à circuler à proximité du matériau électriquement conducteur.

La réalisation de la portion de matériau électriquement conducteur du premier via conducteur et/ou de la portion de matériau électriquement conducteur du via conducteur supplémentaire peut comporter la mise en oeuvre d'un dépôt d'une couche du matériau électriquement conducteur contre au moins une partie des parois latérales du premier trou et/ou du trou supplémentaire.

Le procédé d'encapsulation peut comporter en outre, préalablement au dépôt de la couche de matériau électriquement conducteur, une étape de dépôt d'une première couche de matériau diélectrique contre les parois latérales du premier trou et/ou du trou supplémentaire, ladite couche de matériau électriquement conducteur pouvant être déposée contre la première couche de matériau diélectrique, et/ou comportant en outre une étape de dépôt d'une seconde couche de matériau diélectrique contre la couche de matériau électriquement conducteur.

L'invention concerne également un procédé de réalisation d'un dispositif électronique, comportant au moins la mise en oeuvre d'un procédé d'encapsulation d'un microcomposant tel que décrit ci-dessus, et une solidarisation du substrat sur un support.

Le procédé de réalisation peut comporter en outre la réalisation d'au moins un canal de circulation de fluide dans le support et le couplage dudit canal de circulation de fluide avec au moins une zone de circulation d'un fluide formée à travers le substrat.

Le procédé de réalisation peut comporter en outre la superposition d'une pluralité de composants électroniques dont la réalisation comporte au moins la mise en oeuvre d'un procédé d'encapsulation d'un microcomposant tel que décrit précédemment, les uns sur autres, et le couplage des zones de circulation de fluide desdits composants électroniques les unes aux autres.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1K représentent les étapes d'un procédé d'encapsulation d'un microcomposant, objet de la présente invention, selon un premier mode de réalisation,
- les figures 2 à 6 représentent des étapes d'un procédé d'encapsulation d'un microcomposant, objet de la présente invention, selon plusieurs variantes du premier mode de réalisation,
- les figures 7A à 7I représentent des étapes d'un procédé d'encapsulation d'un microcomposant, objet de la présente invention, selon un deuxième mode de réalisation,
- les figures 8A à 8D représentent des étapes d'un procédé d'encapsulation d'un microcomposant, objet de la présente invention, selon un troisième mode de réalisation,
- les figures 9 et 10A à 10F représentent des vias conducteurs réalisant des fonctions de conduction électrique et de dissipation thermique,
- les figures 11 à 13 représentent des dispositifs électroniques, objets de la présente invention, selon différents modes de réalisation,
- les figures 14A à 14F représentent des étapes de réalisation de vias conducteurs assurant les fonctions de conduction électrique et de dissipation thermique,
- les figures 15 à 17 représentent des composants électroniques comportant un ou plusieurs microcomposants encapsulés selon un procédé, objet de la présente invention,
- la figure 18 représente un microcomposant encapsulé selon un procédé, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

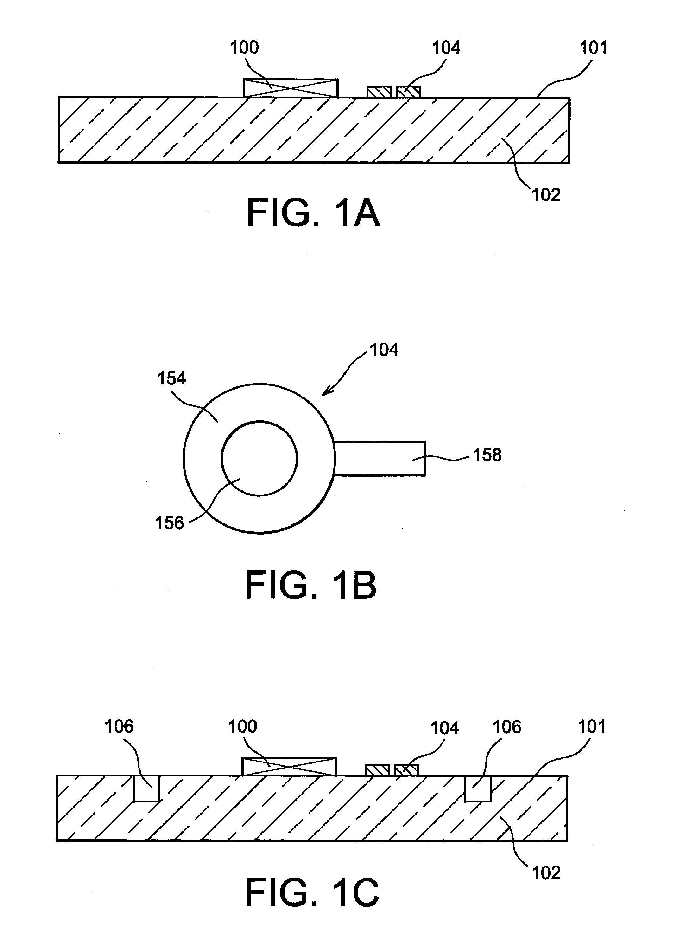

On se réfère tout d'abord aux figures 1A à 1J qui représentent les étapes d'un procédé d'encapsulation d'un microcomposant 100 selon un premier mode de réalisation.

Comme représenté sur la figure 1A, le microcomposant 100, par exemple ici un dispositif de type MEMS, est réalisé sur une face avant 101 d'un substrat 102. Le substrat 102 est par exemple à base de silicium et comporte ici une épaisseur égale à environ 700 µm. Un ou plusieurs plots de contact électrique 104, reliés ou non au microcomposant 100, sont également présents sur la face avant 101 du substrat 102. Sur la figure 1A, un seul plot de contact électrique 104 est présent sur la face 101 du substrat 102.

Dans ce premier mode de réalisation, le plot de contact électrique 104 a ici une forme particulière dite « en corolle ». En effet, comme représenté sur la figure 1B, le plot de contact électrique 104 comporte une partie électriquement conductrice 154, par exemple à base de métal, entourant une partie vide 156. La partie électriquement conductrice 154 a ici une forme d'anneau, ou de couronne. De plus, le plot de contact électrique 104 comporte ici une portion de matériau électriquement conducteur 158 reliant électriquement la partie conductrice 154 en forme d'anneau au microcomposant 100.

Des chemins de découpe 106 du substrat 102 délimitant les différentes puces destinées à être réalisées sur le substrat 102 (dont l'une comporte le microcomposant 100) sont gravés dans le substrat 102, par exemple au niveau de sa face avant 101 et sur une profondeur comprise entre environ 20 µm et 500 µm (figure 1C).

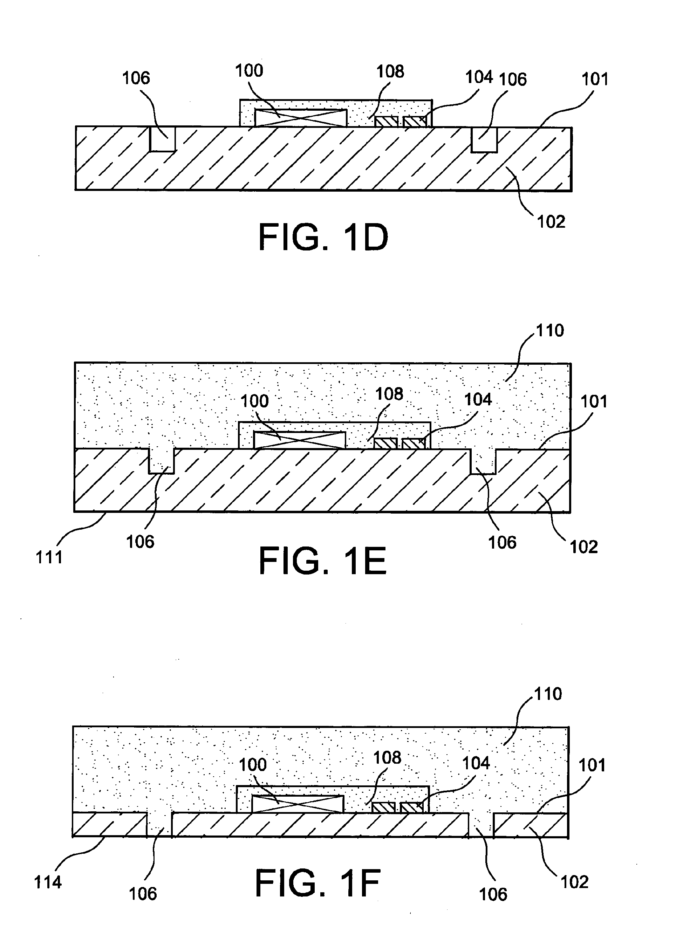

Comme représenté sur la figure 1D, une portion 108 de matériau sacrificiel est ensuite réalisée sur la face avant 101 du substrat 102 afin de recouvrir le microcomposant 100 et le plot de contact électrique 104. Cette portion 108 de matériau sacrificiel est par exemple obtenue en recouvrant la face avant 101 du substrat 102 d'une couche du matériau sacrificiel, par exemple à base de polymère déposé par « spin-on » (dépôt par rotation), d'une résine organique, d'un métal ou d'un diélectrique, qui est ensuite gravée afin d'obtenir la portion 108 de matériau sacrificiel destinée à occuper sensiblement le volume de la future cavité dans laquelle le microcomposant 100 et le plot de contact électrique 104 sont destinés à être encapsulés.

Dans une variante, la portion 108 de matériau sacrificiel pourrait ne recouvrir que le microcomposant 100 et non le plot de contact électrique 104.

Une couche épaisse d'encapsulation 110, qui correspond à une couche de surmoulage, est ensuite déposée sur l'ensemble du substrat 102, c'est-à-dire sur la face avant 101 du substrat 102, dans les chemins de découpe 106 et sur la portion 108 de matériau sacrificiel (figure 1E). Cette couche épaisse d'encapsulation 110 a par exemple une épaisseur supérieure à environ 100 µm, et est à base de résine déposée par exemple par injection, ou à base de matériaux équivalents (résine époxy, ...). Lorsque le plot de contact électrique 104 n'est pas recouvert par le matériau sacrificiel 108, la couche épaisse d'encapsulation 110 recouvre et est en contact avec le plot 104.

Le substrat 102 est ensuite aminci depuis une face arrière 111 opposée à la face avant 101. Sur l'exemple de la figure 1F, l'amincissement est réalisé par exemple par un polissage mécano-chimique avec arrêt sur le matériau de la couche épaisse d'encapsulation 110 disposé dans les chemins de découpe 106.

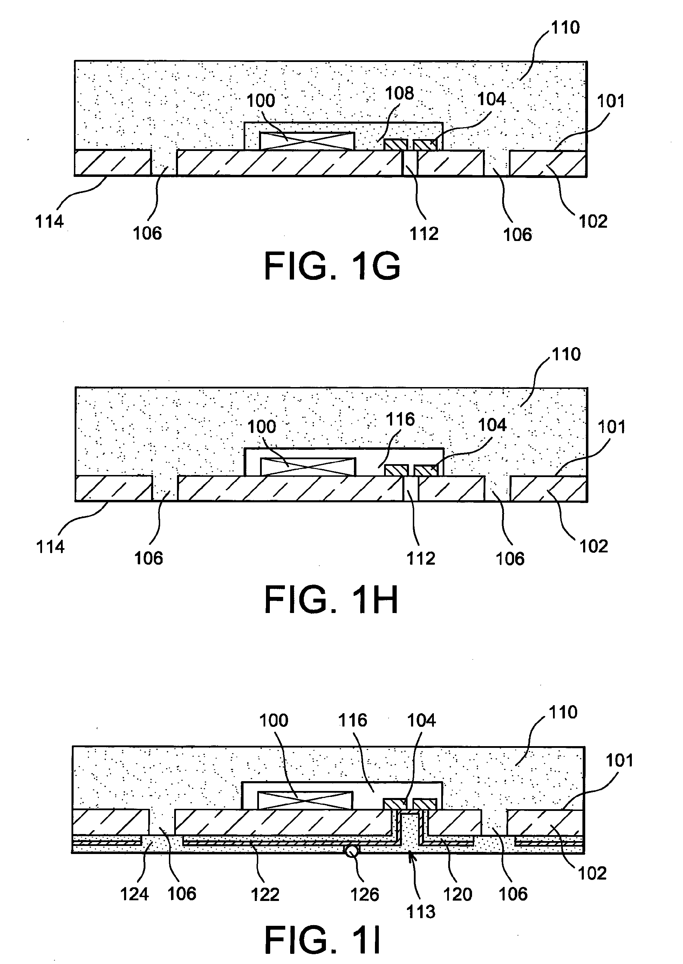

Un trou, ou via traversant, 112 est ensuite réalisé à travers le substrat aminci 102, par exemple par une gravure DRIE (gravure ionique réactive profonde) dans le matériau du substrat 102, formant un accès depuis une face arrière 114 du substrat aminci 102 à la portion 108 de matériau sacrificiel, à travers l'espace vide 156 du plot de contact électrique 104 (figure 1G).

Le trou 112 est aligné avec la partie vide 156 du plot de contact électrique 104, le trou 112 débouchant ainsi sur la surface de la portion 108 de matériau sacrificiel. Cette partie vide 156 peut être réalisée préalablement au dépôt du matériau sacrificiel 108, ou bien être réalisée après avoir formé le trou 112, par une gravure laser, à travers le trou 112, du plot de contact électrique 104 qui, préalablement à cette gravure laser, est une portion « pleine » de matériau électriquement conducteur.

Le via de contact électrique, ou trou de connexion, c'est-à-dire le trou permettant d'accéder électriquement au plot de contact électrique 104, et le via de libération, ou trou de libération, c'est-à-dire le trou permettant d'accéder à la portion 108 de matériau sacrificiel afin de la graver, sont donc ici confondus et formés par un seul et même trou ou via 112.

Dans le cas où la portion 108 de matériau sacrificiel ne recouvre pas le plot 104, le via de contact électrique et le via de libération ne sont pas confondus. Dans ce cas, un via traversant, ou trou, non représenté, différent du via 112 est réalisé à travers le substrat aminci 102 et tel qu'il débouche sur la portion 108 de matériau sacrificiel, formant ainsi un via de libération distinct du via de contact électrique.

Comme représenté sur la figure 1H, la portion 108 de matériau sacrificiel est alors gravée, par exemple par une gravure plasma lorsque le matériau sacrificiel de la portion 108 est un matériau organique, à travers le via de libération, correspondant ici au trou 112, et également à travers l'espace vide 156 du plot de contact électrique 104, formant une cavité 116 dans laquelle le microcomposant 100 et le plot de contact électrique 104 se retrouvent encapsulés.

On réalise alors un dépôt, par exemple de type PECVD, d'une couche diélectrique 120 sur les parois latérales du trou 112 et sur la face arrière 114 du substrat aminci 102. Au cours du dépôt de la couche diélectrique 120, la paroi de fond du trou 112, qui forme un accès au plot de contact électrique 104, est également recouverte par cette couche diélectrique 120. Cette partie de la couche diélectrique 120 recouvrant la paroi de fond du trou 112 est donc retirée par exemple par une lithographie et une gravure par plasma anisotrope de cette partie de la couche diélectrique 120.

Une couche électriquement conductrice 122, par exemple à base de métal déposé par PVD (dépôt physique en phase vapeur) et éventuellement complétée par ECD (dépôt par voie électrolytique), est ensuite déposée sur la couche diélectrique 120 ainsi que sur la paroi de fond du trou 112 afin de former une reprise de contact électrique du plot 104.

En variante, le contact électrique avec le plot 104 peut être réalisé par une sérigraphie d'une colle électriquement conductrice remplissant l'espace restant du trou 112.

Lorsque le via de contact électrique ne sert pas de via de libération, le contact électrique avec le plot 104 peut être réalisé par un dépôt d'une couche électriquement conductrice puis une électrolyse, par exemple de cuivre.

Une couche de passivation 124, à base d'un matériau diélectrique tel qu'une résine, est ensuite déposée, par exemple par laminage d'un film, sur la face arrière de l'ensemble précédemment réalisé, recouvrant la couche diélectrique 120 et la couche électriquement conductrice 122.

On forme ensuite un contact électrique 126 à travers la couche de passivation 124, contactant électriquement le plot de contact 104 par l'intermédiaire de la couche électriquement conductrice 122 (Figure 1I). Ainsi, on obtient un premier via électriquement conducteur 113 réalisé à travers le substrat 102 et relié électriquement au plot de contact électrique 104.

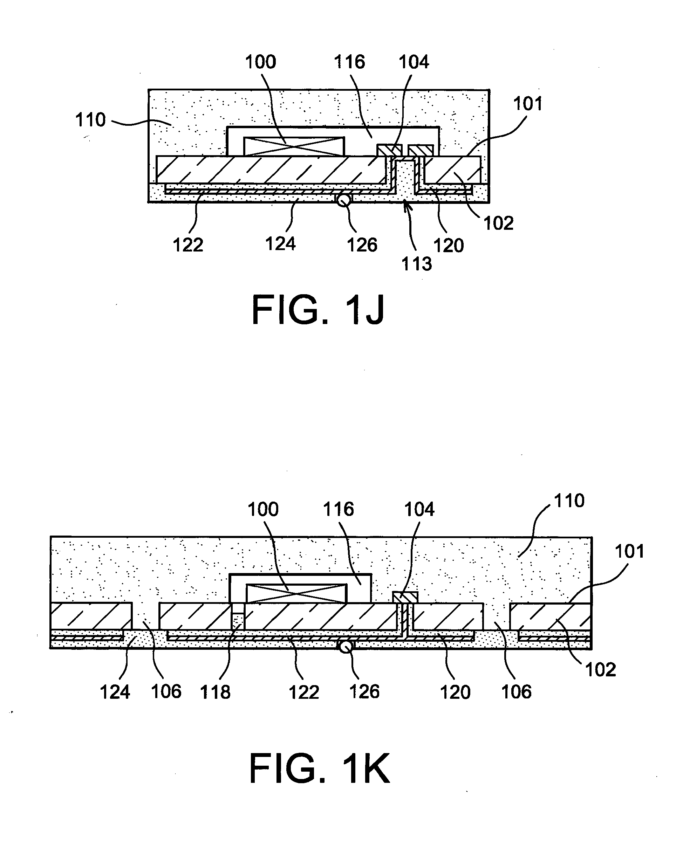

L'ensemble ainsi réalisé est ensuite découpé au niveau des chemins de découpe 106 réalisés dans le substrat 102, permettant d'avoir le microcomposant 100 sous la forme d'une puce individuelle prête à être intégrée sur une carte électronique ou un circuit imprimé (figure 1J).

La figure 1K représente le microcomposant 100 encapsulé obtenu lorsque les trous de libération et de connexion sont distincts. On voit sur cette figure que le plot de contact électrique 104 se trouve en dehors de la cavité 116. De plus, une portion 118 de matériau diélectrique bouche le trou de libération formé à travers le substrat 101. De plus, dans cette configuration, le plot de contact électrique 104 ne comporte pas de partie vide et est formé entièrement de matériau électriquement conducteur.

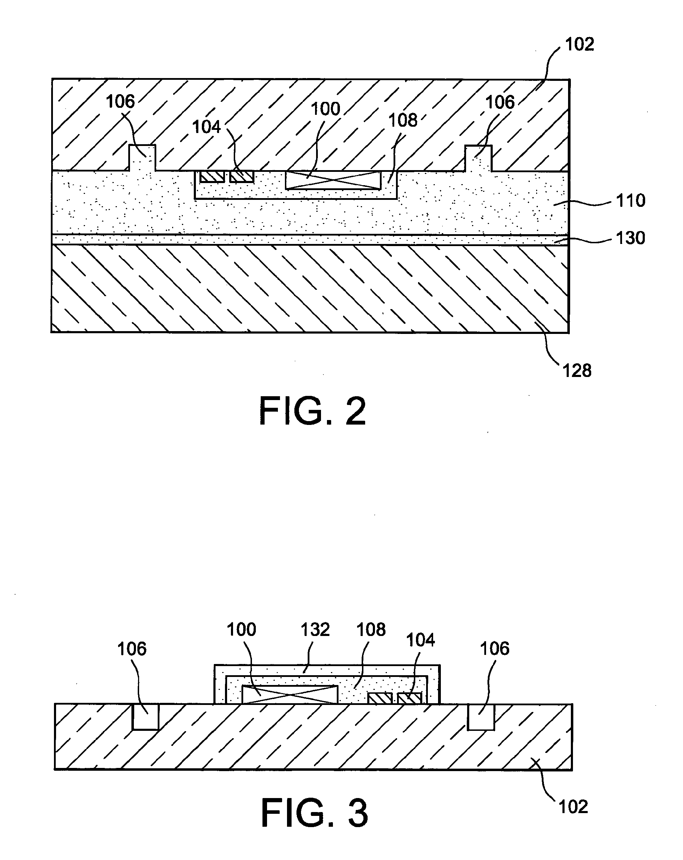

Dans une variante, par exemple lorsque la couche épaisse d'encapsulation 110 n'offre pas une tenue suffisante au substrat 102 après son amincissement ou lorsque le dépôt de la couche épaisse d'encapsulation 110 induit une trop forte flèche sur l'ensemble réalisé, il est possible de reporter temporairement l'ensemble des éléments représentés sur la figure 1E sur un second substrat servant temporairement de poignée mécanique. Ainsi, comme représenté sur la figure 2, la face supérieure de la couche épaisse d'encapsulation 110 est solidarisée à un second substrat 128 par l'intermédiaire d'une couche de collage 130. Les étapes précédemment décrites en liaison avec les figures 1F à 1J sont ensuite mises en oeuvre de manière analogue. Le second substrat 128 peut ensuite être désolidarisé de la couche 110, soit après avoir réalisé la reprise de contact du plot 104, c'est-à-dire entre les étapes représentées sur les figures 1I et 1J, ou bien après avoir réalisé la découpe du substrat 102, c'est-à-dire après l'étape représentée sur la figure 1J.

Lorsque le microcomposant 100 est un composant optique ou optoélectronique, par exemple de type MOEMS, le matériau de la couche épaisse d'encapsulation 110 peut être un matériau au moins partiellement transparent à la lumière.

Selon une autre variante, il est également possible, préalablement au dépôt de la couche épaisse d'encapsulation 110, de recouvrir la portion 108 de matériau sacrificiel d'une couche intermédiaire minérale 132, par exemple à base de SiO₂ et/ou de SiN, par exemple déposée par PECVD (voir figure 3). Cette variante permet d'obtenir une meilleure sélectivité de gravure de la portion 108 de matériau sacrificiel car le matériau de la couche intermédiaire minérale 132 présente une sélectivité de gravure, par rapport au matériau sacrificiel de la portion 108, plus importante que celle obtenue par le matériau de la couche épaisse d'encapsulation 110. Cette variante s'applique aussi bien lorsque la portion 108 de matériau sacrificiel recouvre le plot de contact électrique 104 que lorsqu'elle ne le recouvre pas.

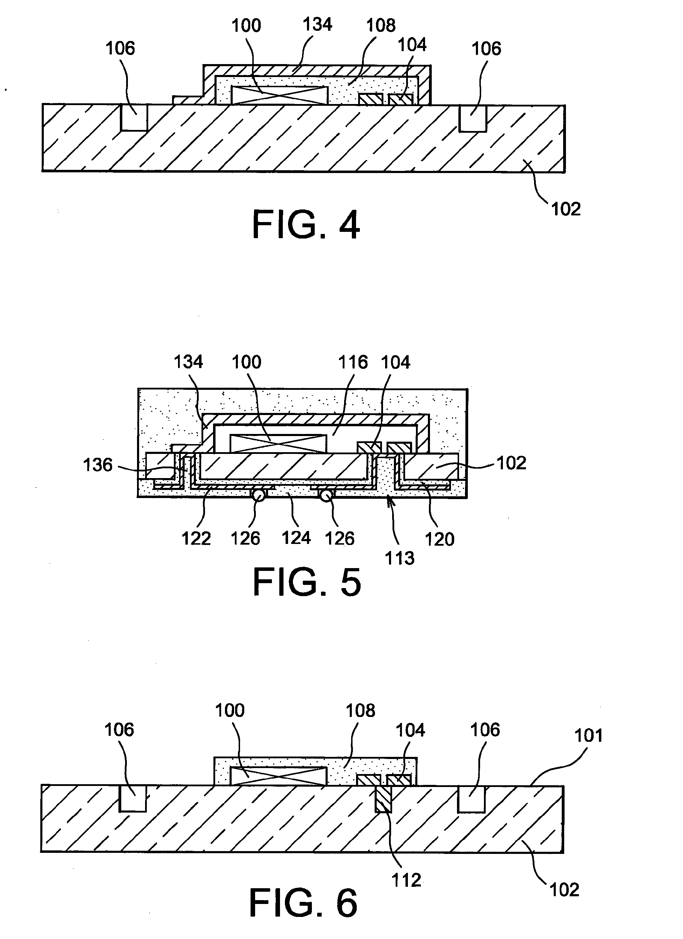

Selon une autre variante, il est également possible, préalablement au dépôt de la couche épaisse d'encapsulation 110, de recouvrir la portion 108 de matériau sacrificiel d'une couche intermédiaire électriquement conductrice 134 telle que représentée sur la figure 4.

Cette couche intermédiaire 134, par exemple à base d'un métal tel que du titane et/ou de l'or et/ou du nickel et/ou du cuivre et/ou de l'AlSi, permet non seulement d'améliorer la sélectivité de gravure de la portion 108 de matériau sacrificiel, mais peut également remplir d'autres fonctions selon la nature du matériau métallique.

Ainsi, la couche intermédiaire 134 peut former par exemple un bouclier électromagnétique, un élément d'un interrupteur, un élément getter absorbant et/ou adsorbant les gaz présents dans la cavité 116 après la gravure de la portion 108 de matériau sacrificiel. De plus, il est possible de réaliser par la suite une reprise de contact électrique de cette couche intermédiaire 134 telle que représentée sur la figure 5.

Pour cela, au moins un deuxième trou 136 est réalisé à travers le substrat aminci 102 afin d'accéder à une portion de la couche intermédiaire 134. La reprise de contact de la couche intermédiaire 134 est réalisée de manière analogue à celle réalisée pour le plot de contact électrique 104 grâce à la couche diélectrique 120, à la couche électriquement conductrice 122 et à un second contact électrique 126 déposées dans le deuxième trou 136. Il convient de remarquer que dans ce cas, la couche électriquement conductrice 122 est interrompue au niveau d'une portion disposée entre les deux contacts électriques 126 afin que le plot de contact électrique 104 ne se retrouve pas en court-circuit avec la couche intermédiaire 134.

Cette variante s'applique aussi bien lorsque la portion 108 de matériau sacrificiel recouvre le plot de contact électrique 104 que lorsqu'elle ne le recouvre pas.

Les variantes précédemment décrites en liaison avec les figures 3 à 5 dans lesquelles une couche intermédiaire de matériau est intercalée entre la portion 108 de matériau sacrificiel et la couche épaisse d'encapsulation 110 autorisent en outre de réaliser une encapsulation sous vide ou sous atmosphère contrôlée du microcomposant 100 compte tenu de l'herméticité pouvant être obtenue dans la cavité 116 grâce à la nature du matériau de la couche intermédiaire minérale 132 et/ou la couche intermédiaire électriquement conductrice 134. Il est possible de réaliser le bouchage du ou des trous formant un accès à la cavité 116 par la mise en oeuvre d'un dépôt sous vide, par exemple une évaporation ou une pulvérisation cathodique sous angle, c'est-à-dire en donnant un angle à la plaque (substrat 102) lors du dépôt, ce qui permet de déposer le matériau de bouchage sur les flancs du trou de libération sans venir déposer du matériau de bouchage dans la cavité 116.

L'herméticité de l'encapsulation ainsi réalisée peut être assurée du fait que les matériaux utilisés pour réaliser la couche intermédiaire minérale 132 et/ou la couche intermédiaire électriquement conductrice 134 et le matériau de bouchage 118 aient chacun une perméation faible.

Selon une autre variante, il est également possible de réaliser le trou 112 préalablement au dépôt de la portion 108 de matériau sacrificiel et préalablement à la réalisation du plot de contact électrique 104. Ainsi, lors de la réalisation du plot de contact électrique 104 sur la face avant 101 du substrat 102, le trou 112 préalablement réalisé au niveau de l'emplacement du plot de contact électrique 104, est rempli du matériau électriquement conducteur formant le plot de contact électrique 104 (voir figure 6). Les autres étapes précédemment décrites en liaison avec les figures 1E à 1J sont alors mises en oeuvre. L'amincissement du substrat 102 peut être réalisé jusqu'au niveau du trou 112. Toutefois, afin de graver la portion 108 de matériau sacrificiel, il est nécessaire au préalable de supprimer au moins partiellement le matériau électriquement conducteur se trouvant dans le trou 112 qui sert de via de libération du microcomposant 100. De plus, il est possible que le trou 112 soit rempli par une couche du matériau électriquement conducteur recouvrant la paroi latérale du via et qu'un autre matériau tel que du silicium soit ensuite déposé au centre du via. Avec un tel via « en anneaux », il est possible de supprimer ensuite la partie centrale en silicium afin de former un accès pour graver la portion 108 de matériau sacrificiel.

Lorsque le via de libération est distinct du via de contact électrique, il est possible de ne remplir que le via de contact électrique par le matériau électriquement conducteur.

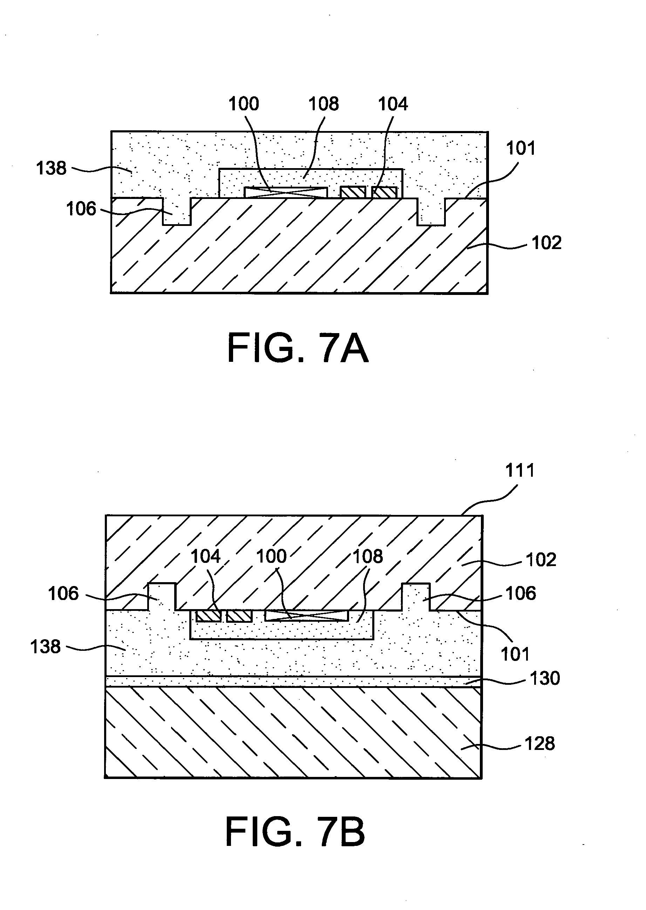

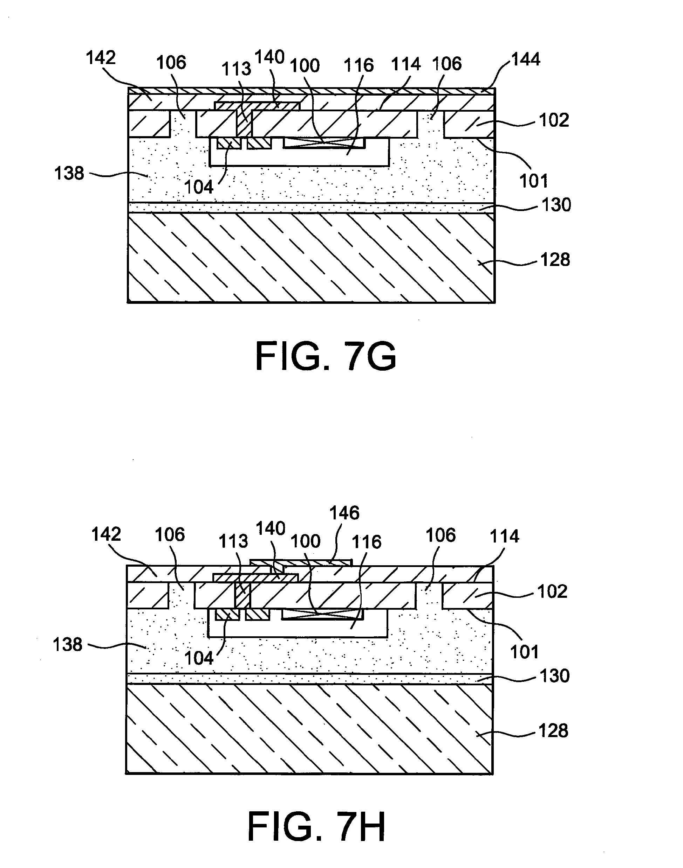

On se réfère aux figures 7A à 7I qui représentent les étapes d'un procédé d'encapsulation du microcomposant 100 selon un deuxième mode de réalisation.

Selon ce deuxième mode de réalisation, on réalise tout d'abord les étapes précédemment décrites en liaison avec les figures 1A à 1D.

Puis, comme représenté sur la figure 7A, on recouvre le substrat 102 d'une couche épaisse d'encapsulation 138 à base d'un matériau composite de circuit imprimé, par exemple de type prepreg, RCC (« Resin-Coated Copper » en anglais) ou un composite de résine époxy renforcé de fibre de verre (matériau FR4).

La couche épaisse d'encapsulation 138 peut donc comporter une résine époxy associée ou non à une feuille de cuivre, et être formée par exemple par pressage sur la face avant 101 du substrat 102, dans les chemins de découpe 106 et sur la portion 108 de matériau sacrificiel.

Afin d'éviter une trop forte flèche de l'ensemble réalisé, l'ensemble des éléments représentés sur la figure 7A est reporté temporairement sur un second substrat servant temporairement de poignée mécanique. Ainsi, comme représenté sur la figure 7B, la face supérieure de la couche 138 est solidarisée à un second substrat 128 par l'intermédiaire d'une couche de collage 130, de manière analogue à la variante décrite en liaison avec la figure 2.

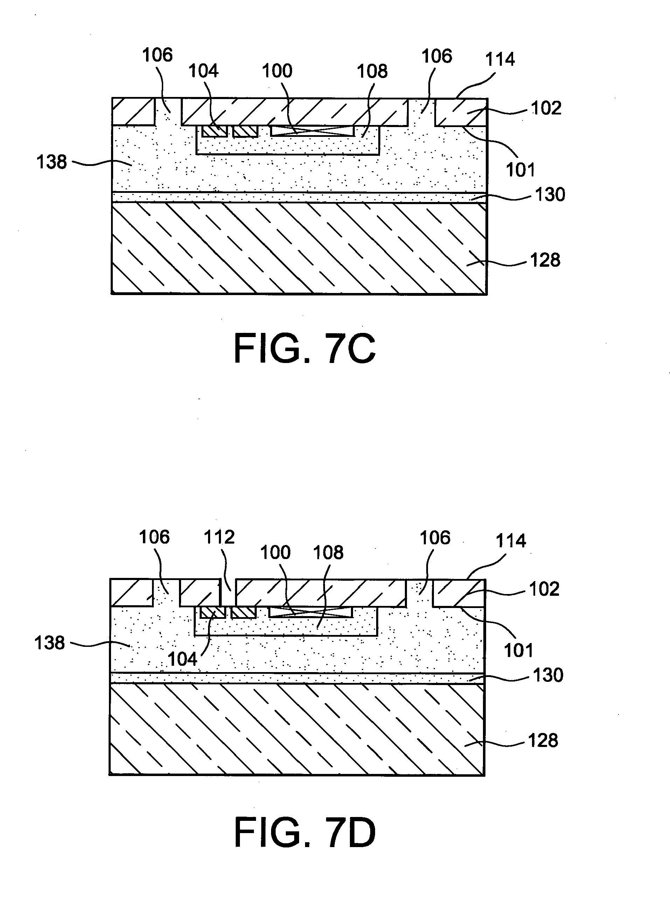

Le substrat 102 est ensuite aminci depuis sa face arrière 111 opposée à la face avant 101, par exemple par un polissage mécano-chimique avec arrêt sur le matériau de la couche 138 disposé dans les chemins de découpe 106 (figure 7C).

Un via traversant, ou trou, 112 est ensuite réalisé à travers le substrat aminci 102, formant un accès depuis la face arrière 114 du substrat aminci 102 au plot de contact électrique 104, et à la portion 108 de matériau sacrificiel à travers la partie vide du plot de contact électrique 104 (figure 7D).

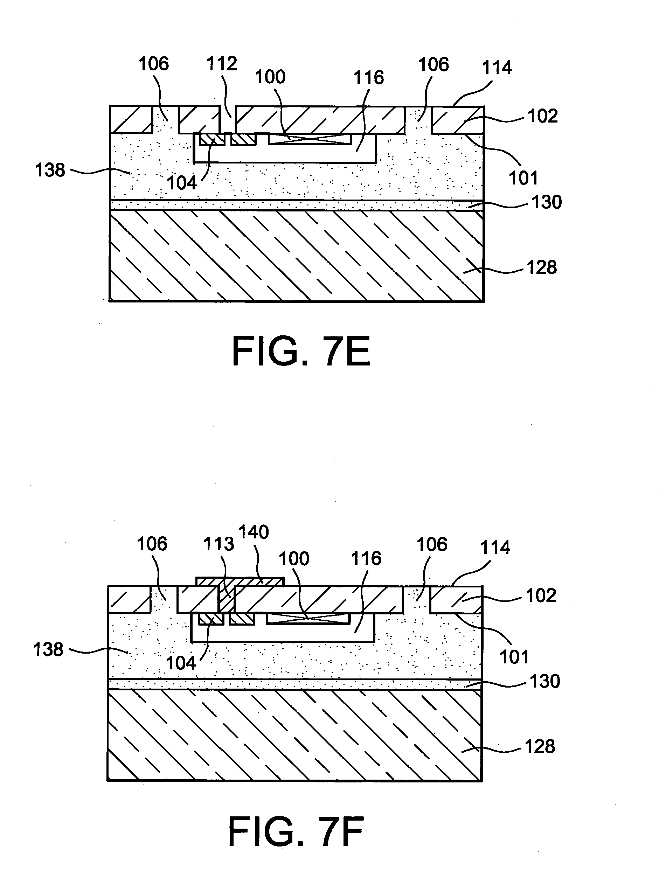

Comme représenté sur la figure 7E, la portion 108 de matériau sacrificiel est alors gravée, par exemple par une gravure plasma lorsque le matériau sacrificiel de la portion 108 est un matériau organique, à travers le trou 112 et le plot de contact électrique 104, formant une cavité 116 dans laquelle le microcomposant 100 se retrouve encapsulé.

On réalise ensuite une reprise de contact électrique en remplissant le trou 112 par un matériau électriquement conducteur, par exemple en sérigraphiant un polymère conducteur, formant un contact électrique 140 au niveau de la face arrière 114 du substrat aminci 102 relié électriquement au contact électrique 104 par le via conducteur 113 (figure 7F).

Comme représenté sur la figure 7G, la face arrière 114 du substrat aminci 102 est recouverte d'un bicouche composite formé par une couche 142 pouvant être à base d'un matériau analogue à celui de la couche épaisse d'encapsulation 138, par exemple de la résine époxy, et par une couche 144 à base d'un matériau électriquement conducteur, par exemple du cuivre.

Ce bicouche composite recouvre également le contact électrique 140.

La couche 144 est ensuite gravée. Une portion restante 146 de la couche 144 est ensuite reliée électriquement, par exemple par l'intermédiaire d'un via métallisé formé à travers la couche 142, au contact électrique 140.

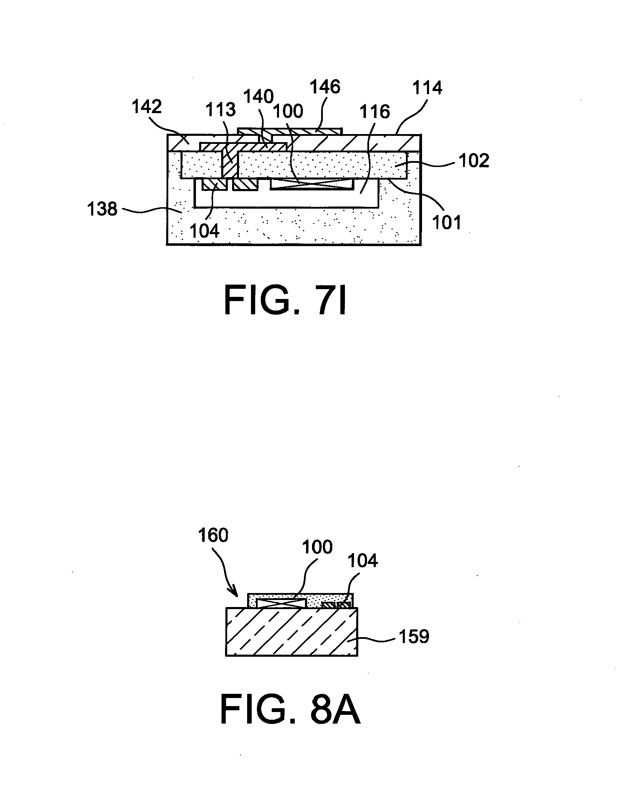

Le second substrat 128 et la couche de collage 130 sont ensuite supprimés. L'ensemble ainsi réalisé est ensuite découpé au niveau des chemins de découpe 106 réalisés dans le substrat 102, permettant d'avoir le microcomposant 100 sous la forme d'une puce individuelle prête à être intégrée sur une carte électronique (figure 7I). De plus, compte tenu des matériaux utilisés pour former la couche 138 et la couche 142, qui sont des matériaux utilisés pour réaliser les circuits imprimés, la puce obtenue forme une partie d'un circuit imprimé qui ne nécessite pas la mise en oeuvre d'étapes de pré-packaging pour être intégrée à un circuit imprimé.

Les variantes précédemment décrites en liaison avec le premier mode de réalisation peuvent également s'appliquer à ce deuxième mode de réalisation. De plus, il est également possible que le via servant à graver la portion 108 de matériau sacrificiel et le via relié électriquement au plot 104 soient distincts et non confondus.

Les figures 8A à 8D représentent les étapes d'un procédé d'encapsulation d'un microcomposant 100 selon un troisième mode de réalisation. Ce troisième mode de réalisation comporte la mise en oeuvre de techniques dite de plaquette reconstruite (néowafer ou « rebuild wafer » en anglais).

Les étapes précédemment décrites en liaison avec les figures 1A à 1D sont mises en oeuvre afin de recouvrir le microcomposant 100 et éventuellement le plot de contact électrique 104 par la portion 108 de matériau sacrificiel, par exemple à base d'un matériau organique. Des puces 160, dont l'une comporte le microcomposant 100, sont ensuite séparées par une découpe du substrat 102, chaque puce 160 comportant une portion 159 du substrat 102 (figure 8A).

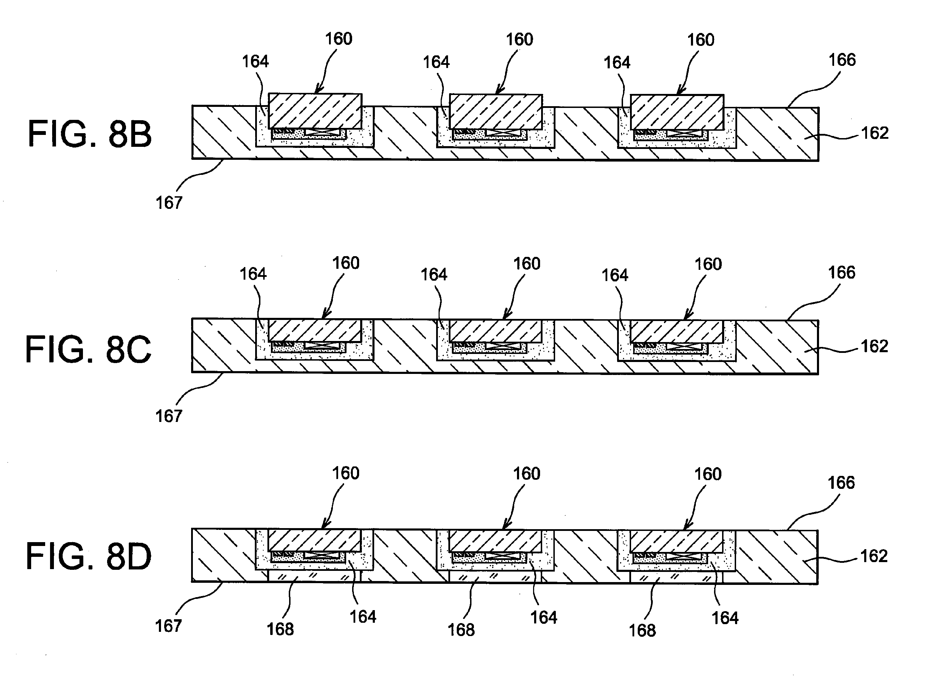

Chaque puce individuelle 160 dont le microcomposant et éventuellement le plot de contact électrique sont protégés par une portion 108 de matériau sacrificiel est ensuite reportée dans une préforme par exemple à base de polymère injecté et dont les dimensions correspondent à celles d'un substrat, ou encore dans un substrat 162 comprenant plusieurs emplacements dans lesquels les puces 160 sont disposées et maintenues par un matériau d'adhérence 164 tel que de la colle disposée dans les emplacements (figure 8B).

L'épaisseur des portions du substrat 162 se trouvant en regard des puces 160 est supérieure ou égale à environ 100 µm.

Le matériau d'adhérence 164 est ensuite polymérisé, puis un amincissement est réalisé au niveau d'une face avant 166 du substrat 162. Si les puces 160 dépassent de la face avant 166 du substrat 162, comme c'est le cas sur l'exemple représenté sur la figure 8B, ce sont les portions de substrat 102 des puces 160 qui dépassent de la face avant 166 du substrat 162 qui sont amincies (figure 8C). Toutefois, si ce sont les portions du substrat 162 qui se trouvent entre les puces 160 qui dépassent et forme un relief par rapport aux puces 160, ce sont alors ces portions du substrat 162 qui sont amincies.

Les autres étapes d'encapsulation des microcomposants des puces 160 mises en oeuvre correspondent aux autres étapes précédemment décrites pour les autres modes de réalisation, comme par exemple les étapes précédemment décrites en liaison avec les figures 1G à 1J.

Lorsque les microcomposants des puces 160 sont des dispositifs optiques ou optoélectroniques, il est possible de prévoir, au niveau d'une face arrière 167 du substrat 162, au fond des emplacements destinés à recevoir les puces 160, des portions 168 d'un matériau optiquement transparent, par exemple à base de verre (figure 8D).

Dans tous les modes de réalisation précédemment décrits, le plot de contact électrique comporte une portion de matériau électriquement conducteur entourant une partie vide, ladite partie vide formant, avec un trou, ou via traversant, réalisé depuis la face arrière du substrat, un accès à une portion de matériau sacrificiel destinée à être gravée pour libérer le microcomposant.

Dans les modes de réalisation où les trous des vias conducteurs ne sont pas complètement bouchés, ils peuvent également avoir une fonction de dissipation thermique. On peut dans ce cas réaliser au moins deux trous. Ces trous remplissent alors une triple fonction : électrique, thermique et de libération.

La forme du plot de contact électrique peut être différente.

Lorsque le via de libération et le via de conduction électrique sont distincts, le plot de contact électrique peut être juste une portion de matériau électriquement conducteur ne comportant pas de partie vide étant donné que dans ce cas, le plot de contact électrique ne participe pas à former un accès à la portion de matériau sacrificiel.

De plus, la section du ou des plots de contact électriques peut être différente de celle représentée sur la figure 1B, par exemple rectangulaire, ovale, ou d'une toute autre forme. Enfin, la partie vide du plot de contact électrique peut être formée après la formation du via de connexion, en supprimant une partie du plot de contact.

Dans tous les modes de réalisation précédemment décrits, il est possible qu'un ou plusieurs autres vias électriquement conducteurs soient réalisés à travers le substrat 102, par exemple à côté de la cavité 116 dans laquelle est encapsulé le microcomposant 100, afin d'assurer une fonction de connexion électrique avec d'autres éléments. Dans ce cas, au moins une partie de ces vias conducteurs peuvent également remplir une fonction de dissipation thermique.

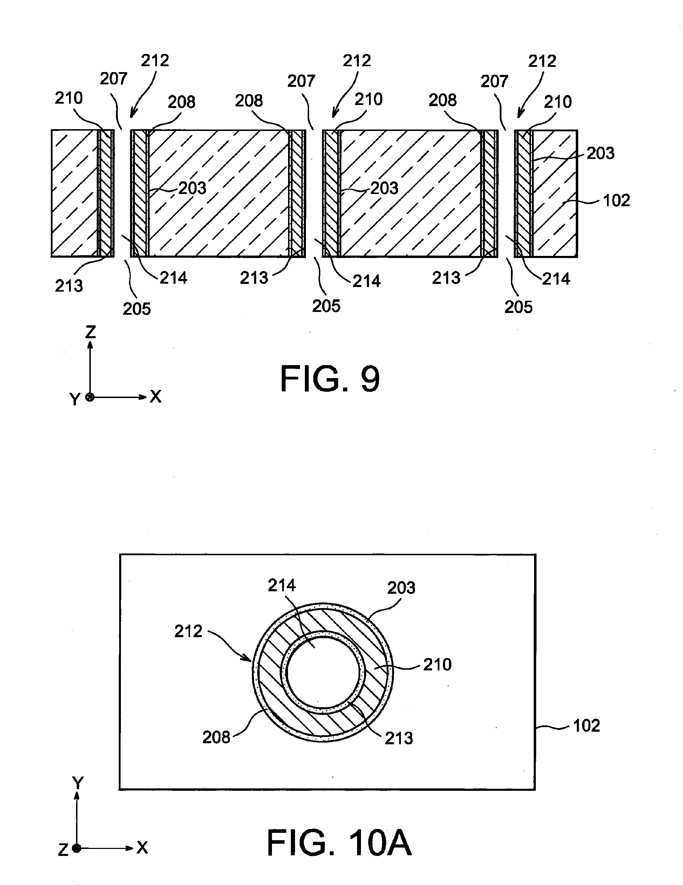

Les figures 9 et 10A représentent respectivement une vue en coupe de côté et une vue de dessus de tels trous de connexion, ou vias conducteurs 212 ou TSV (« Through Silicon Via » en anglais), réalisant à la fois une fonction de conduction électrique (ou transfert de signal électrique) et une fonction de refroidissement, ou dissipation thermique, du composant dont fait partie le substrat 102.

Les vias conducteurs 212 traversent le substrat 102 depuis sa face avant jusqu'à sa face arrière. Chacun des vias conducteurs 212 s'étend donc entre une première extrémité 205 se trouvant au niveau de la face arrière du substrat 102 et une seconde extrémité 207 se trouvant au niveau de la face avant du substrat 102.

Les vias conducteurs 212 ont ici une forme sensiblement cylindrique. Les dimensions des vias conducteurs, et notamment le diamètre, sera fonction de la technologie mise en oeuvre pour les réaliser et est par exemple compris entre environ 1 µm et plusieurs centaines de µm.

Chaque via conducteur 212 est réalisé à partir d'un trou 203 traversant le substrat 102 depuis sa face avant jusqu'à sa face arrière. Sur l'exemple des figures 9 et 10A, chacun des vias conducteurs 212 comporte une première portion diélectrique formée par une couche 208, de forme sensiblement cylindrique et à base d'un matériau diélectrique, par exemple un matériau minéral tel que du SiO₂ ou du SiN, ou un polymère, recouvrant les parois latérales du trou 203. Cette couche 208 est par exemple issue de la couche diélectrique 120 précédemment décrite et déposée lors de la réalisation du premier via conducteur 113.

Cette première couche diélectrique 208 est recouverte d'une deuxième couche 210, également de forme sensiblement cylindrique, à base d'un matériau électriquement conducteur tel qu'un métal ou un polymère chargé en particules électriquement conductrices. Cette deuxième couche 210 forme la portion de matériau électriquement conducteur du via conducteur 212 assurant la fonction de transfert, ou de conduction, électrique de signaux entre la face avant et la face arrière du substrat 102. Le matériau de la deuxième couche 210 est de préférence choisi tel qu'il forme un bon conducteur thermique, par exemple un métal. Cette deuxième couche 210 est par exemple réalisée par le dépôt de la couche électriquement conductrice 122 lors de la réalisation du premier via conducteur 113. La première couche 208 forme une isolation électrique entre le substrat 102 et la deuxième couche 210 électriquement conductrice. La deuxième couche électriquement conductrice 210 peut être réalisée à partir d'un ou plusieurs des matériaux indiqués ci-dessous pour lesquels la valeur de la conductivité thermique, en W.m⁻¹.K⁻¹, est également indiquée.
Al : 216 W.m⁻¹.K⁻¹
Cu : 394 W.m⁻¹.K⁻¹
Sn : 63 W.m⁻¹.K⁻¹
Ni: 90 W.m⁻¹.K⁻¹
Au : 291 W.m⁻¹.K⁻¹
W : 197 W.m⁻¹.K⁻¹

La deuxième couche 210 est recouverte d'une troisième couche 213, également de forme sensiblement cylindrique et à base d'un matériau diélectrique, par exemple un matériau minéral tel que du SiO₂ ou du SiN, ou un polymère. La troisième couche 213 délimite un espace vide 214 du via conducteur 212 formant une zone de circulation d'un fluide caloporteur, tel qu'un liquide caloporteur ou un gaz, destiné à refroidir le composant électronique comprenant le substrat 102. Cet espace vide 214 a également une forme sensiblement cylindrique.

Les couches diélectriques 208 et 213 peuvent avoir chacune une épaisseur comprise entre environ 10 nm et quelques micromètres (par exemple inférieure à environ 10 µm) notamment lorsque le diélectrique est un matériau minéral. La deuxième couche 210 peut avoir une épaisseur comprise entre environ quelques dizaines de nanomètres et plusieurs micromètres, par exemple comprise entre environ 10 nm et 10 µm, lorsque cette deuxième couche 210 est à base d'un matériau métallique. L'épaisseur de la deuxième couche 210 pourra être supérieure à environ 10 µm lorsqu'elle est réalisée à partir de polymère chargé de particules électriquement conductrices.

Grâce aux vias conducteurs 212, on réalise, au sein de mêmes intraconnexions, une fonction électrique de transfert de signaux entre les faces avant et arrière du substrat 102, grâce à la couche 210 électriquement conductrice, et une fonction de refroidissement grâce à la zone de circulation d'un fluide caloporteur formée par les espaces vides 214 qui traversent ici le substrat 102 dans toute son épaisseur.

Les vias conducteurs 212 peuvent être intégrés en grand nombre dans le composant, permettant de réaliser une évacuation de la chaleur au plus près de la source chaude du composant électronique. Ainsi, l'intégration de ces vias conducteurs au sein même du composant qui comporte ou forme une source de chaleur, permet d'éviter la formation de points chauds à l'intérieur du composant. Par exemple, si le dispositif comporte une zone chaude au niveau de sa face avant, la circulation d'un liquide ou d'un gaz caloporteur à travers les espaces vides 214 permet d'évacuer la chaleur par l'intermédiaire de ce liquide ou ce gaz qui capte cette chaleur et l'évacue hors du composant. La face arrière du substrat forme donc une zone de chaleur intermédiaire.

Bien que les vias conducteurs 212 aient, sur les figures 9 et 10A, chacun une forme cylindrique, il est possible que ces vias conducteurs aient une toute autre forme à partir du moment où les vias conducteurs comportent au moins une portion de matériau électriquement conducteur assurant une fonction de conduction électrique et au moins un espace vide formant une zone de circulation pour un fluide caloporteur.

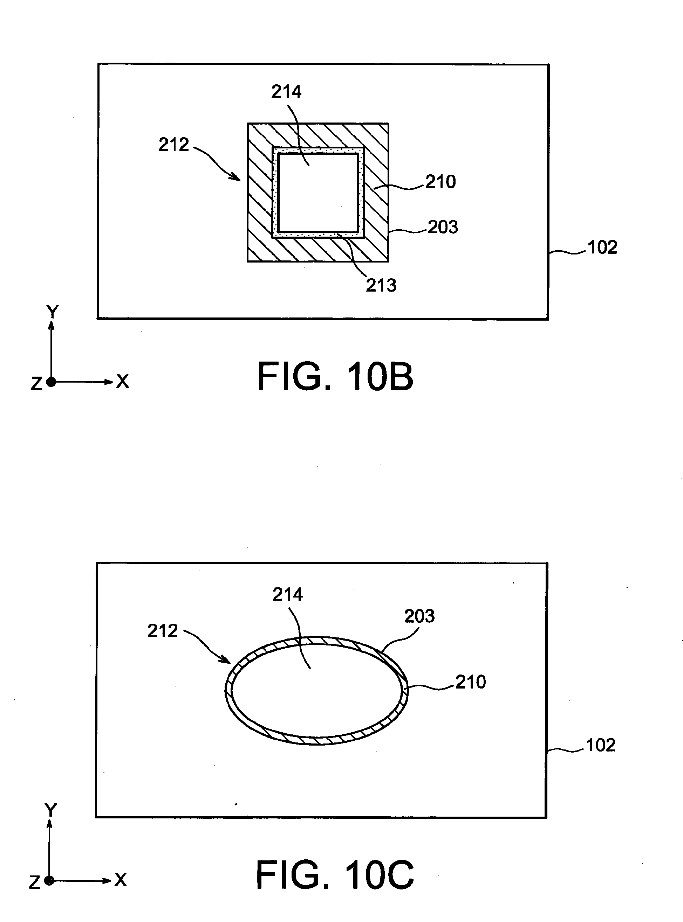

Les figures 10B à 10F représentent des vues en coupe de dessus de différentes variantes de réalisation d'un via conducteur 212.

Sur l'exemple représenté sur la figure 10B, le trou 203 comporte une section, dans le plan (X,Y) (plan parallèle aux faces avant et arrière du substrat 102), de forme rectangulaire. Le trou 203 a donc une forme parallélépipédique rectangle. L'espace vide 214 comporte également, dans le plan (X,Y), une section de forme rectangulaire. De plus, contrairement aux vias conducteurs précédemment décrits en liaison avec les figures 9 et 10A, le via conducteur 212 représenté sur la figure 10B ne comporte pas de couche diélectrique entre la couche électriquement conductrice 210 et le substrat 102, la couche électriquement conductrice 210 étant directement en contact avec les parois latérales du trou 203. De manière générale, la couche diélectrique 208 pourra être présente lorsqu'il existe un besoin d'isoler électriquement le substrat 102 de la couche électriquement conductrice 210.

Une autre variante de réalisation d'un via conducteur 212 est représentée sur la figure 10C. Dans cette variante, le trou 203 a une section, dans le plan(X,Y), de forme ovale. De plus, contrairement aux exemples de réalisation précédemment décrits, le via conducteur 212 ne comporte pas la couche diélectrique 213. Le via conducteur 212 est donc ici formé de la couche électriquement conductrice 210 disposée contre les parois latérales du trou 203 et de l'espace vide 214 dont la section, dans le plan (X,Y), est également ovale.

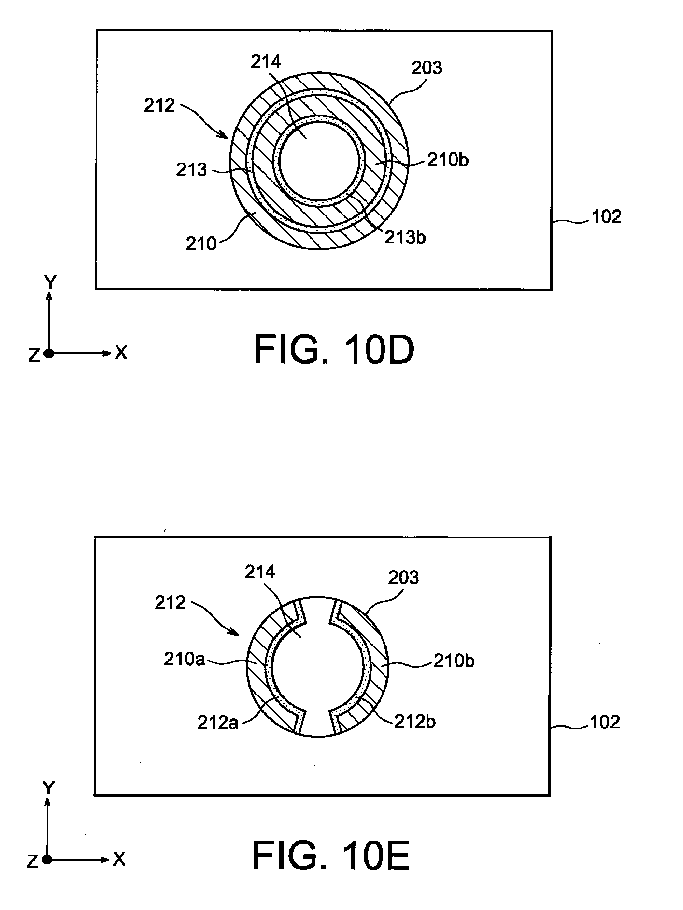

Une autre variante de réalisation d'un via conducteur 212 est représentée sur la figure 10D. Dans cette variante, le via conducteur 212 comporte une première couche électriquement conductrice 210 disposée contre les parois latérales du trou 203, une première couche diélectrique 213 disposée contre la première couche électriquement conductrice 210, une seconde couche électriquement conductrice 210b disposée contre la première couche diélectrique 213, et une seconde couche diélectrique 213b disposée contre la seconde couche électriquement conductrice 210b. Chacune de ces couches 210, 213, 210b et 213b comporte une section, dans le plan (X,Y), en forme de couronne et entourent l'espace vide 214. Dans cette variante, on a donc plusieurs parties électriquement conductrices concentriques remplissant la fonction de conduction électrique entre les faces avant et arrière du substrat 102, ces parties pouvant être indépendantes ou non en fonction de la présence ou non d'une couche diélectrique entre ces parties.

Une autre variante de réalisation d'un via conducteur 212 est représentée sur la figure 10E. Dans cette variante, le via conducteur 212 comporte deux portions disjointes 210a, 210b électriquement conductrices disposées contre les parois latérales du trou 203. Chacune de ces portions 210a, 210b comporte une section, dans le plan (X,Y), en forme d'une portion de couronne. De plus, chacune de ces portions 210a, 210b est recouverte d'une portion diélectrique 212a, 212b assurant une isolation entre l'espace vide 214 et les portions électriquement conductrices 210a, 210b.

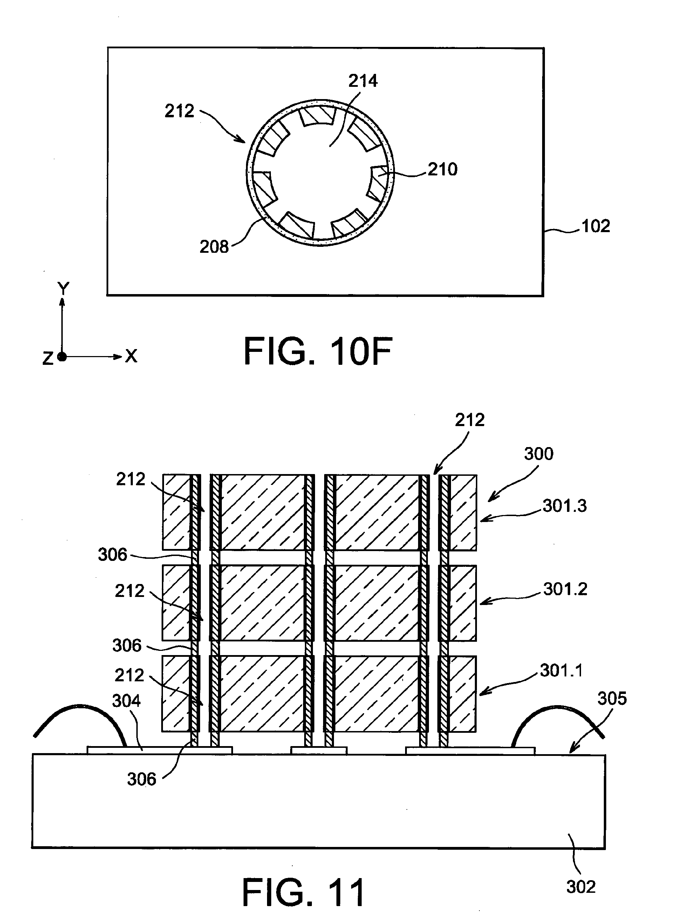

Une autre variante de réalisation d'un via conducteur 212 est représentée sur la figure 10F. Dans cette variante, le via conducteur 212 comporte plusieurs portions disjointes 210 électriquement conductrices, par exemple 7, disposées contre une couche diélectrique 208 recouvrant les parois latérales du trou 203. Chacune de ces portions 210 comporte une section, dans le plan (X,Y), en forme d'une portion de couronne. Il est possible, comme du l'exemple de la figure 10E, que les portions électriquement conductrices 210 soient recouvertes par une couche diélectrique afin d'isoler ces portions 210 de l'espace vide 214.

Dans les variantes représentées sur les figures 10E et 10F, les portions électriquement conductrices forment, dans le via conducteur 212, un contact électrique discontinu, c'est-à-dire plusieurs contacts électriques. Ainsi, il est possible de contacter plusieurs plots de contact électriques distincts présents sur une même face du substrat tout en conservant un via conducteur assurant les fonctions de conduction électriques et thermiques. De plus, les zones libres entre les portions électriquement conductrices 210 du via conducteur permettent également la circulation du fluide (gaz ou liquide) caloporteur, ce qui autorise de réduire les dimensions de la section centrale de l'espace vide 214 et donc de réduire le diamètre du via conducteur 212 (dimension jusqu'à environ 10 µm).

Les différentes variantes précédemment décrites en liaison avec les figures 10A à 10F peuvent se combiner entre elles : présence ou non d'une ou plusieurs des couches diélectriques 208, 213, 213b, forme de la section du trou 203 du via conducteur 212 et des couches disposées contre les parois latérales du trou 203, présence d'une ou plusieurs couches 210, 210a, 210b électriquement conductrices, sous la forme d'une ou plusieurs portions disjointes, pour remplir la fonction de conduction électrique du via conducteur 212.

Quelle que soit la forme du trou 203, il est possible que l'espace vide 214 soit rempli par un matériau poreux, par exemple un matériau de type solgel poreux, les porosités formant alors l'espace de circulation du fluide à travers le via conducteur 212. Dans ce cas, une couche diélectrique, par exemple la couche 213, pourra assurer l'isolation entre la couche électriquement conductrice 210 et le matériau poreux.

La figure 11 représente schématiquement un dispositif électronique 300 selon un premier mode de réalisation, comportant plusieurs composants électroniques superposés.

Le dispositif électronique 300 comporte une carte électronique, ou circuit imprimé, formant un support 302. Des contacts électriques 304 sont réalisés sur une face avant 305 du support 302. Le dispositif électronique 300 comporte en outre trois composants électroniques 301.1 à 301.3, empilés les uns sur les autres et disposés sur la face avant 305 du support 302. Les composants électroniques 301.1 à 301.3 peuvent chacun avoir des rôles différents (mémoire, fonctions logiques, MEMS, composants passifs, gestion d'alimentation, etc.). Bien que non représenté, au moins l'un des composants électronique 301.1 à 301.3 comporte, sur et/ou dans un substrat du composant, un microcomposant, similaire au microcomposant 100 précédemment décrit, encapsulé selon l'un des procédés d'encapsulation précédemment décrits en liaison avec les figures 1 à 8D. Chacun des composants électroniques 301.1 à 301.3 comporte des vias conducteurs 212 similaires aux vias conducteurs 212 précédemment décrits en liaison avec les figures 9 à 10F, c'est-à-dire permettant de réaliser une fonction de conduction électrique et une fonction de dissipation thermique au sein des composants électroniques 301.1 à 301.3, et plus généralement une fonction de refroidissement du dispositif électronique 300.

Un premier composant électronique 301.1 comporte des vias conducteurs 212, et plus particulièrement les couches électriquement conductrices 210 de ces vias conducteurs 212, reliés électriquement aux contacts électriques 304 par des interconnexions électriques 306 disposées entre la face arrière du premier composant 301.1 et les contacts électriques 304. Un deuxième composant électronique 301.2 est disposé sur le premier composant 301.1, les vias conducteurs 212 du deuxième composant 301.2 étant reliés électriquement, au niveau d'une face arrière du deuxième composant 301.2, aux vias conducteurs 212 du premier composant 301.1, au niveau d'une face avant du premier composant 301.1. Les couches électriquement conductrices 210 des vias conducteurs 212 des composants électroniques 301.1 et 301.2 sont reliées électriquement entre elles par l'intermédiaire d'interconnexions électriques 306, par exemple similaires à celles reliant électriquement les contacts électriques 304 aux vias conducteurs 212 du premier composant 301.1, disposées entre le premier composant 301.1 et le deuxième composant 301.2. Ces interconnexions électriques 306 peuvent être des interconnexions métalliques isolées telles que des microbilles, des piliers métalliques ou des micro-inserts, ou bien être des interconnexions à base de polymère chargé en particules électriquement conductrices. Les interconnexions électriques 306 sont ici adaptées de façon à permettre la circulation du fluide entre les composants 301.1 à 301.2 tout en formant une connexion électrique entre les vias conducteurs 212 de ces composants 301.1 à 301.2.

De manière analogue, un troisième composant électronique 301.3 est disposé sur le deuxième composant 301.2, les vias conducteurs 212 du troisième composant 301.3 étant reliés électriquement, au niveau d'une face arrière du troisième composant 301.3, aux vias conducteurs 212 du deuxième composant 301.2, au niveau d'une face avant du deuxième composant 301.2, par des interconnexions électriques 306 disposées entre le deuxième composant 301.2 et le troisième composant 301.3.

Ainsi, dans le dispositif électronique 300, les vias conducteurs 212 des composants électroniques 301.1 à 301.3 couplés entre eux par les interconnexions électriques 306 forment un espace de circulation d'un fluide caloporteur permettant de refroidir chacun des composants électroniques 301.1 à 301.3, et donc refroidir le dispositif électronique 300. Le fluide caloporteur peut par exemple être introduit au niveau de la face avant du dispositif 300, c'est-à-dire par les vias conducteurs 212 du troisième composant 301.3 au niveau de la face avant du troisième composant 301.3. Ce fluide, et donc la chaleur, est alors évacué par les vias conducteurs 212 du premier composant 301.1, entre la face arrière du premier composant 301.1 et le support 302. Un espace est donc conservé entre le premier composant 301.1 et le support 302 afin que le fluide puisse s'échapper de l'espace de circulation du fluide formé par les vias conducteurs 212. La circulation du fluide caloporteur au sein du dispositif électronique 300 permet d'uniformiser la température du dispositif électronique 300 et de préparer au mieux l'étape d'évacuation de la chaleur vers l'extérieur, par exemple via un échangeur thermique et/ou un micro caloduc intégré, ou tout autre système adéquat que peut comporter le dispositif électronique 300 et qui n'est pas représenté sur la figure 11. Dans l'exemple décrit ici, étant donné que le fluide caloporteur est évacué entre le premier composant électronique 301.1 et le support 302, le fluide caloporteur est de préférence un gaz car un liquide pourrait créer des courts-circuits si celui-ci était évacué entre le support 302 et le premier composant électronique 301.1.

Dans une variante, il est possible, notamment lorsque la densité de connexions du dispositif électronique est faible devant la surface du dispositif électronique, d'associer les vias conducteurs 212 précédemment décrits avec des canaux de circulation de fluide caloporteur, également appelés vias thermiques, servant uniquement à la fonction de refroidissement thermique du dispositif. Ces vias thermiques pourront être réalisés en même temps que les vias conducteurs 212, et peuvent donc bénéficier de tous les avantages liés au procédé de réalisation mis en oeuvre à l'échelle du dispositif 300. Les vias thermiques peuvent être réalisés en gravant des trous, par exemple de forme sensiblement cylindrique, à travers les substrats des composants électroniques 301.1 à 301.3 du dispositif 300, sans disposer de matériau électriquement conducteur dans les trous. De même, il est également possible qu'une partie des vias conducteurs du dispositif 300 n'assurent qu'une fonction de transfert électrique, ces vias ne comportant alors pas d'espaces vides permettant de faire circuler un fluide caloporteur.

Lorsque le fluide caloporteur est un liquide, par exemple de l'eau éventuellement dé-ionisée, le circuit de circulation du fluide formé par les vias conducteurs 212 doit être fermé et étanche, les interconnexions entre les composants étant également étanches. Par contre, lorsque le fluide caloporteur est un gaz, par exemple de l'air ou tout autre gaz, le circuit de circulation du fluide peut être ouvert ou fermé, c'est-à-dire étanche ou non, et la circulation du gaz peut être naturelle ou forcée par un élément extérieur, par exemple par un ventilateur.

La dissipation thermique intra-composant se fait par épanouissement horizontal et vertical au sein même du composant. Ainsi, à partir du point chaud initial, l'évacuation de la chaleur se fait par une répartition vers l'extérieur, par l'intermédiaire du substrat.

Dans le premier mode de réalisation décrit en liaison avec la figure 11, les vias conducteurs 212 des composants électroniques 301.1 à 301.3 sont alignés les uns par rapport aux autres. Un tel alignement est par exemple obtenu lorsque les composants 301.1 à 301.3 sont des composants similaires, le dispositif électronique 300 étant alors homogène.

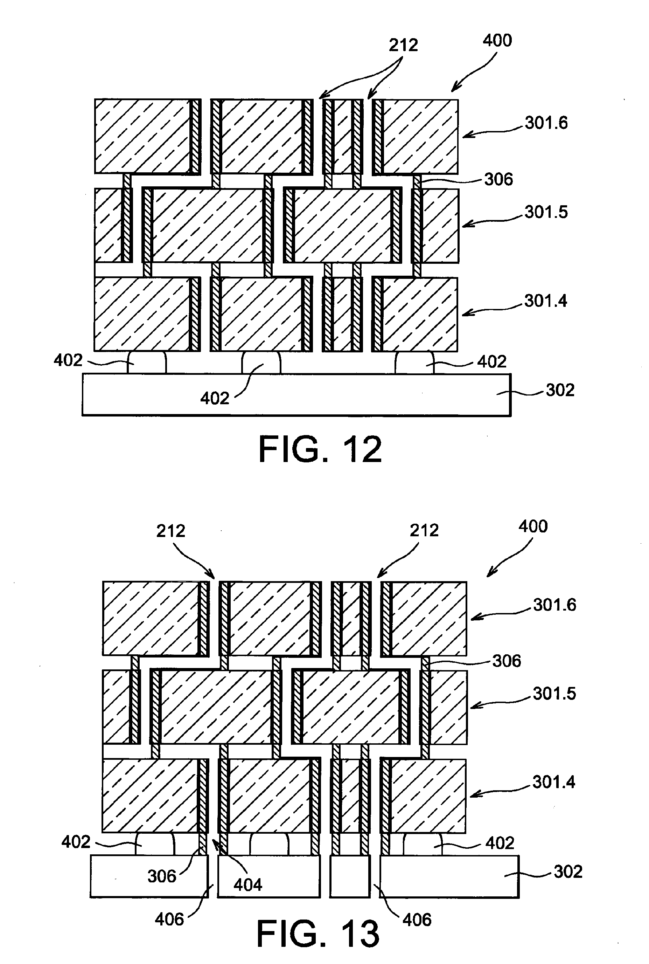

Un dispositif électronique 400 selon un deuxième mode de réalisation est représenté sur la figure 12.

De manière analogue au dispositif électronique 300, le dispositif électronique 400 comporte trois composants électroniques 301.4 à 301.6 superposés et interconnectés les uns aux autres par l'intermédiaire d'interconnexions électriques 306 reliant électriquement les vias conducteurs 212 des composants électroniques 301.4 à 301.6 superposés.

Contrairement au composant électronique 301.1 précédemment décrit, le composant électronique 301.4 est relié au support 302 par des microbilles 402.

De plus, contrairement au dispositif électronique 300 dans lequel les vias conducteurs 212 des composants 301.1 à 301.3 sont alignés les uns au-dessus des autres, les vias conducteurs des composants électroniques 301.4 à 301.6 ne sont pas alignés les uns par rapport aux autres. Une telle configuration se retrouve par exemple lorsque les composants électroniques 301.4 à 301.6 sont différents et que le dispositif électronique 400 est un dispositif hétérogène. Toutefois, les interconnexions électriques 306 sont positionnées de façon à ce que les vias conducteurs 212 des composants électroniques 300.4 à 300.6 forment un circuit de circulation d'un fluide caloporteur.

Le circuit de circulation de fluide formé par les vias conducteurs 212 du dispositif électronique 400 n'est ici pas étanche, le fluide étant évacué dans l'espace formé entre le support 302 et la face arrière du composant électronique 301.4 qui est solidarisé au support 302.

Dans une variante représentée sur la figure 13, les ouvertures formées par les vias conducteurs 212 au niveau de la face arrière du composant électronique 301.4 débouchent dans des espaces étanches 404 formés entre le support 302 et le composant électronique 301.4. Des trous 406 sont également réalisés à travers le support 302 afin que le fluide destiné à circuler à travers les vias conducteurs 212 soit évacué en dehors du dispositif électronique 400. Ainsi, le circuit de circulation du fluide caloporteur formé dans le dispositif électronique 400 représenté sur la figure 13 est étanche et permet de faire circuler par exemple de l'eau dé-ionisée pour refroidir le dispositif électronique 400.

Dans le cas particulier des interconnexions étanches, le dispositif électronique peut donc former un micro-caloduc 3D, à condition de bien choisir le liquide caloporteur en fonction des températures attendues (chaleur latente d'évaporation inférieure à la température maximum du système). La circulation du fluide est alors autonome dans le dispositif électronique.

De manière générale, les vias conducteurs 212 des dispositifs électroniques 300 et 400 peuvent être réalisés selon l'une quelconque des variantes de réalisation précédemment décrites en liaison avec les figures 10A à 10F.

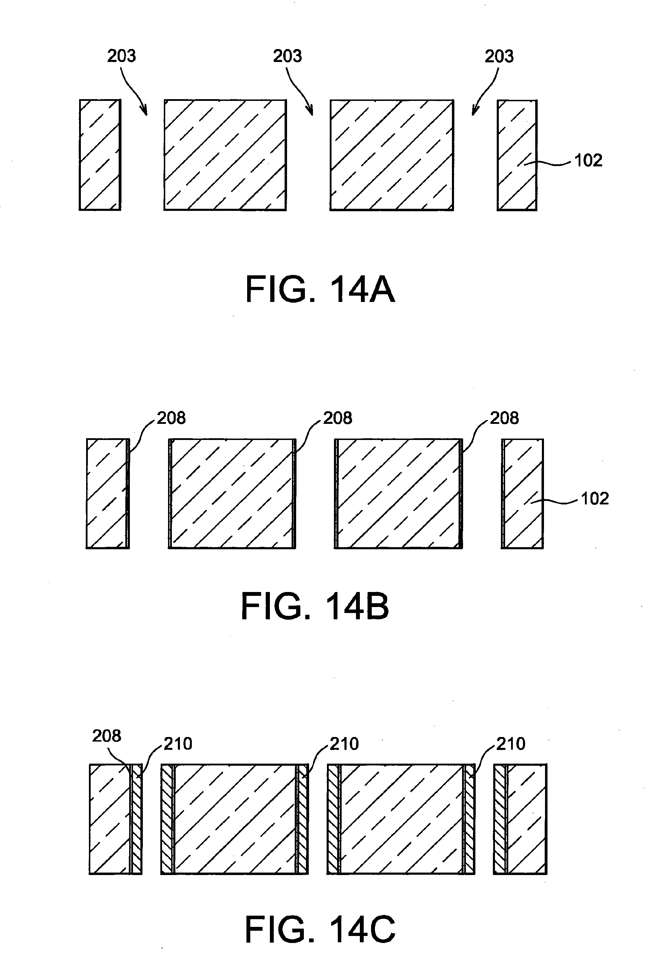

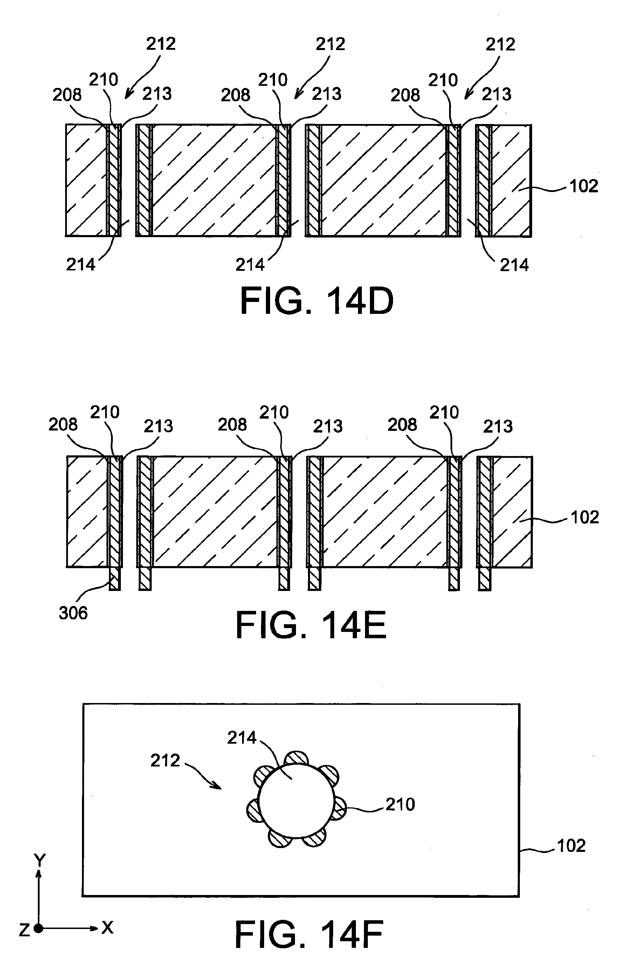

On se réfère maintenant aux figures 14A à 14E qui représentent les étapes de réalisation des vias conducteurs 212, dans un substrat 102 d'un composant électronique, assurant les fonctions de conduction électrique et de dissipation thermique. Bien que non représenté, le composant électronique dans lequel sont réalisés les vias conducteurs 212 comporte également un microcomposant encapsulé et libéré via un trou servant également à la réalisation d'un via électriquement conducteur.

Comme représenté sur la figure 14A, on grave tout d'abord à travers le substrat 102 des trous 203 de forme sensiblement cylindrique, destinés à former les vias conducteurs 212. Les trous 203 sont formés à travers la face avant et débouchent au niveau de la face arrière du substrat 102. Ces trous 203 peuvent être obtenus par la mise en oeuvre d'une gravure de type DRIE (gravure ionique réactive), laser, chimique, ou encore chimique photo-assistée.

Les parois latérales des trous 203 sont ensuite recouvertes par les premières couches 208 de matériau diélectrique (figure 14B). Ces premières couches 208 sont par exemple obtenues par la mise en oeuvre d'un dépôt de type PECVD (dépôt chimique en phase vapeur assisté par plasma), CVD (dépôt chimique en phase vapeur), dépôt à la tournette (« spin coating » en anglais), dépôt par pulvérisation, laminage, ou encore par sérigraphie, ce dépôt pouvant correspondre au dépôt de la couche 120 lors de la réalisation du premier via conducteur 113 précédemment décrit.

Comme représenté sur la figure 14C, les premières couches 208 sont ensuite recouvertes par les deuxièmes couches 210 électriquement conductrices. Ces deuxièmes couches 210 sont par exemple obtenues par la mise en oeuvre d'un dépôt de type PECVD, CVD, dépôt à la tournette, dépôt par pulvérisation, laminage, sérigraphie, ou par un dépôt électrochimique ou électrolytique, ce dépôt pouvant correspondre au dépôt de la couche 122 précédemment décrit pour la réalisation du premier via conducteur 113.

Les deuxièmes couches 210 sont recouvertes par les troisièmes couches 213 de matériau diélectrique (figure 14D). Ces troisièmes couches 213 sont par exemple obtenues par la mise en oeuvre d'un dépôt de type PECVD, CVD, dépôt à la tournette (« spin coating » en anglais), dépôt par pulvérisation, laminage ou par sérigraphie, ce dépôt pouvant correspondre au dépôt de la couche 124 précédemment décrit pour la réalisation du premier via conducteur 113. Les espaces restants 214 des trous 203 forment les espaces de circulation de fluide caloporteur des vias conducteurs 212.

Enfin, des interconnexions électriques 306 sont formées au niveau de la face arrière du substrat 102, au niveau des vias conducteurs 212. Ces interconnexions électriques 306 sont reliées électriquement aux deuxièmes couches 210 électriquement conductrices et sont destinées à interconnecter les deuxièmes couches 210 à des contacts électriques réalisés sur un support ou à des vias conducteurs d'un autre composant électronique sur lequel ce composant est destiné à être empilé.

Lorsque le fluide caloporteur utilisé est un liquide ou un gaz particulier, des techniques de scellement hermétique entre les composants électroniques pourront être mises en oeuvre afin que les espaces de circulation du fluide caloporteur soient fermés hermétiquement : scellement métallique eutectique (AuSn, SnAG, AuSi, etc.), scellement moléculaire direct (SiO₂/SiO₂, ...), ou encore, lorsque les composants électroniques comportent par exemple des substrats chargés électrostatiquement et supportent des tensions de scellement, de type bonding anodique.

Lorsque les vias conducteurs 212 comportent plusieurs portions électriquement conductrices 210 distinctes, ces portions peuvent être réalisées en technologie additive à partir d'une photolithographie : les portions électriquement conductrices discontinues sont créées par exemple par une croissance électrolytique dans le trou 203 à partir d'un masque de résine.

En variante, il est également possible de réaliser ces portions en technologie soustractive. Dans ce cas, plusieurs plots électriquement conducteurs sont réalisés dans l'épaisseur du substrat 102. Le trou 203 est ensuite réalisé à travers le substrat 102 de manière à traverser une partie du substrat 102 où se situe une partie des plots conducteurs, et ainsi à entamer et retirer une partie des plots conducteurs, la partie restante de chaque plot formant une des portions électriquement conductrices 210. On obtient ainsi une configuration telle que représentée sur la figure 14F.

Dans une autre variante de réalisation, il est possible de déposer sur les parois latérales du trou 203 (éventuellement recouvertes au préalable d'une couche isolante) une couche électriquement conductrice. Des rainures sont ensuite gravées dans la couche électriquement conductrice afin que les portions restantes de la couche électriquement conductrice forment les portions 210 disjointes.

Selon un autre exemple de réalisation, on forme dans le substrat 102, le trou 203 et des rainures le long de la ou des parois latérales du trou 203, en même temps ou consécutivement. Puis, on dépose une couche de matériau sacrificiel dans les rainures ou sur les parois des rainures, le matériau sacrificiel étant réparti de manière à former une séparation entre le trou 203 et les rainures. La couche de matériau sacrificiel peut être prévue de manière à dépasser dans le trou 203. Le matériau sacrificiel peut être par exemple du SiO₂ ou du Si₃N₄. Puis, on dépose une couche de matériau conducteur de manière à tapisser les parois du trou 203 et recouvrir le matériau sacrificiel. L'épaisseur de la couche de matériau conducteur peut être prévue inférieure à l'épaisseur de la couche de matériau sacrificiel dépassant dans le trou 203. On retire ensuite la couche de matériau sacrificiel, ce qui entraine un retrait du matériau conducteur en regard des rainures par exemple par gravure chimique humide. A l'issue de ce retrait, la zone conductrice est sous forme de plusieurs parties conductrices 210 distinctes qui ne sont pas connectées entre elles et sont séparées à l'aide des rainures.

Selon un autre exemple de réalisation, on réalise dans le substrat 102 le trou 203 traversant le substrat 102 ainsi qu'au moins une rainure verticale s'étendant dans l'épaisseur du substrat 102, et communiquant avec le trou 203. La rainure peut avoir par exemple une section rectangulaire ou ovale. Des parties d'une paroi latérale du trou 203 forment une séparation entre cette dernière et la rainure. On effectue ensuite un dépôt du matériau électriquement conducteur de manière à recouvrir une paroi de la cavité et sur une partie de la rainure. Les parties formant la séparation empêchent, par effet d'ombrage, d'effectuer un dépôt du matériau conducteur tout autour de la rainure de sorte que le dépôt du matériau conducteur sur la paroi de la cavité et sur la rainure, forme une zone discontinue. Le dépôt du matériau électriquement conducteur peut être éventuellement un dépôt dit « directionnel » dans lequel le matériau est dispensé selon un angle prédéterminé par rapport à une normale aux faces avant et arrière du substrat 102. On peut ainsi réaliser une portion conductrice le long de la rainure, qui est déconnectée d'autres portions électriquement conductrices formées sur ladite paroi lors du dépôt du matériau conducteur.

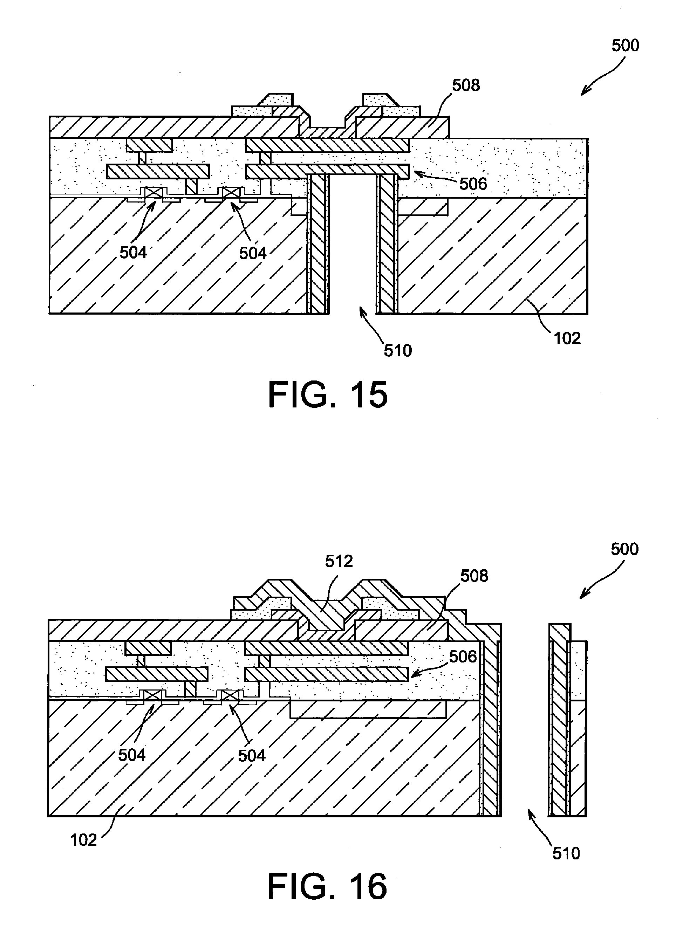

On se réfère maintenant à la figure 15 qui représente un composant électronique 500 selon un autre mode de réalisation. Par rapport aux composants électroniques précédemment décrits, une partie des éléments actifs et des couches d'interconnexion électrique du composant électronique sont représentés.

Le composant électronique 500 comporte le substrat 102 sur lequel sont réalisés des transistors MOS 504. Bien que non représenté, un microcomposant encapsulé similaire au microcomposant 100 précédemment décrit est réalisé sur le substrat 102, ce microcomposant ayant été libéré via un trou de libération réalisé à travers le substrat 102, ce trou servant également à former un via conducteur relié électriquement à un plot de connexion électrique disposé dans la cavité dans laquelle est encapsulé le microcomposant.

Le composant 500 comporte également un premier niveau métallique d'interconnexion 506 auquel sont reliés électriquement les transistors MOS 504. Ce premier niveau métallique d'interconnexion 506 est relié à un second niveau métallique d'interconnexion 508. Le composant électronique 500 comporte également des vias conducteurs 510 similaires aux vias conducteurs 212 précédemment décrits. Sur l'exemple de la figure 15, un seul via conducteur 510 est représenté.

Le via conducteur 510 est relié électriquement au premier niveau métallique d'interconnexion 506. Toutefois, contrairement aux vias conducteurs 212 précédemment décrits, ce via conducteur 510 est borgne, c'est-à-dire fermé au niveau d'une de ses extrémités, sa paroi de fond étant formée par une portion du premier niveau métallique d'interconnexion 506. La couche électriquement conductrice du via conducteur 510 est reliée électriquement à cette portion du premier niveau métallique d'interconnexion 506. Afin d'éviter un court-circuit entre le premier niveau d'interconnexion 506 et un autre élément électrique, l'espace vide du via conducteur 510 est destiné à recevoir un gaz en tant que fluide caloporteur.

Comme représenté sur la figure 16, il est également possible que le via conducteur 510 soit réalisé à travers toute l'épaisseur du composant électronique 500. Dans cette variante, le via conducteur 510 est relié électriquement à un niveau de redistribution métallique 512, formant un contact électrique, réalisé sur la face avant du composant électronique 500. La prise de contact avec le via conducteur 510 est réalisée en périphérie de celui-ci afin de ne pas occulter l'espace vide du via conducteur 510 et ainsi permettre une circulation d'un fluide liquide ou gazeux à travers le via conducteur 510.

Il est également possible que le composant électronique 500 comporte à la fois des vias conducteurs 510a similaires au via conducteur 510 précédemment décrit en liaison avec la figure 15, c'est-à-dire non débouchant au niveau d'une des faces du composant électronique 500, et des vias conducteurs 510b similaires au via 510 précédemment décrit en liaison avec la figure 16, c'est-à-dire qui traversent le composant électronique 500 sur tout son épaisseur.

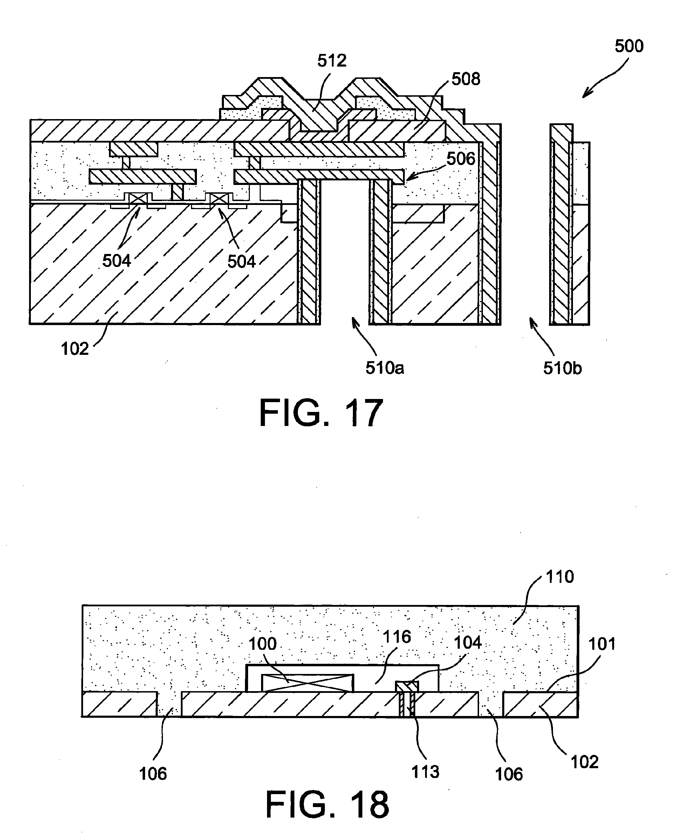

Une telle configuration est par exemple représentée sur la figure 17.

Dans les exemples précédemment décrits, les vias conducteurs sont réalisés dans ou à travers des composants électroniques empilés. De tels vias conducteurs assurant à la fois une fonction de conduction électrique et une fonction de refroidissement peuvent également jouer un rôle de trou de libération lors de l'encapsulation de microcomposants réalisés sur et/ou dans ces composants électroniques.

Cette fonction de dissipation thermique peut également remplie par le premier via conducteur 113 précédemment décrit en liaison avec les figures 1 à 8D. Ainsi, comme représenté sur la figure 18, le premier via conducteur 113 ayant servie à graver un matériau diélectrique entourant le microcomposant 100, formant ainsi la cavité 116, est réalisé de manière analogue à l'un des vias conducteurs 212 afin d'assurer un contact électrique avec le plot de contact électrique 104. Le premier via conducteur 113 comporte également un espace vide traversant le substrat 102 et formant une zone de circulation de fluide, ici de l'air, entre l'intérieur et l'extérieur de la cavité 116.

## Revendications

1. Procédé d'encapsulation d'au moins un microcomposant (100) disposé sur une première face (101) d'un substrat (102) et/ou dans le substrat (102), comportant au moins les étapes de :
a) réalisation d'au moins un plot de contact électrique (104) sur la première face (101) du substrat (102),
b) réalisation d'au moins une portion (108) de matériau sacrificiel recouvrant au moins le microcomposant (100) et au moins une partie du plot de contact électrique (104),
c) réalisation d'au moins une couche épaisse d'encapsulation (110, 138, 162) recouvrant la portion (108) de matériau sacrificiel et au moins une partie de la première face (101) du substrat (102),
d) réalisation, à travers une seconde face (114), opposée à la première face (101), du substrat (102), d'au moins un premier trou (112) aligné au moins partiellement avec le plot de contact électrique (104) et débouchant au niveau de la portion (108) de matériau sacrificiel,
e) suppression de la portion (108) de matériau sacrificiel à travers le premier trou (112),
f) réalisation, au moins dans le premier trou (112), d'au moins une portion de matériau électriquement conducteur (122, 140) reliée électriquement au plot de contact électrique (104), formant un premier via conducteur (113).

2. Procédé d'encapsulation selon la revendication 1, dans lequel le plot de contact électrique (104) comporte au moins une portion (154) de matériau électriquement conducteur entourant au moins un espace vide (156), le premier trou (112) étant aligné avec l'espace vide (156).

3. Procédé d'encapsulation selon la revendication 2, dans lequel la portion (154) de matériau électriquement conducteur a, dans un plan parallèle à la première face (101) du substrat (102), une forme d'anneau.

4. Procédé d'encapsulation selon l'une des revendications précédentes, dans lequel l'étape c) est obtenue par le dépôt d'une résine de type polymère formant la couche épaisse d'encapsulation (110, 138).

5. Procédé d'encapsulation selon l'une des revendications 1 à 3, dans lequel l'étape c) est obtenue :
- en découpant une portion (159) du substrat (102) contre laquelle sont disposés le microcomposant (100), le plot de contact électrique (104) et la portion (108) de matériau sacrificiel, puis
- en disposant ladite portion (159) du substrat (102), le microcomposant (100), le plot de contact électrique (104) et la portion (108) de matériau sacrificiel dans un emplacement formé dans au moins un second substrat (162) formant la couche épaisse d'encapsulation.

6. Procédé d'encapsulation selon l'une des revendications précédentes, comportant en outre la mise en oeuvre, après l'étape c), d'un amincissement du substrat (102) au niveau de sa seconde face (114).

7. Procédé d'encapsulation selon l'une des revendications précédentes, comportant en outre la mise en oeuvre, après l'étape c), d'une étape de solidarisation de la couche épaisse d'encapsulation (110, 138) à au moins un second substrat (128).

8. Procédé d'encapsulation selon l'une des revendications précédentes, comportant en outre la mise en oeuvre, entre les étapes b) et c), d'une étape de dépôt d'au moins une couche intermédiaire (132, 134) à base d'au moins un matériau minéral diélectrique et/ou d'au moins un matériau électriquement conducteur recouvrant la portion (108) de matériau sacrificiel, la couche épaisse d'encapsulation (110, 138, 162) recouvrant au moins la couche intermédiaire (132, 134).

9. Procédé d'encapsulation selon la revendication 8, dans lequel, lorsque la portion (108) de matériau sacrificiel est recouverte par la couche intermédiaire (134) à base du matériau électriquement conducteur, au moins une portion de matériau électriquement conducteur (122) est disposée sur la seconde face (114) du substrat (104) et reliée électriquement à la couche intermédiaire (134) à travers au moins un deuxième trou (136) réalisé à travers la seconde face (114) du substrat (102) et débouchant au niveau de la couche intermédiaire (134).

10. Procédé d'encapsulation selon l'une des revendications précédentes, comportant en outre la mise en oeuvre, avant l'étape c), d'une étape de réalisation de chemins de découpe (106) dans le substrat (102), et, après l'étape c), d'une étape de découpe du substrat (102) selon les chemins de découpe (106).

11. Procédé d'encapsulation selon l'une des revendications précédentes, comportant en outre, lorsque la portion de matériau électriquement conducteur (122, 140) reliée électriquement au plot de contact électrique (104) ne bouche pas le premier trou (112), un dépôt sur et/ou dans le premier trou (112) d'un matériau diélectrique bouchant le premier trou (112).

12. Procédé d'encapsulation selon l'une des revendications précédentes, comportant en outre la réalisation d'au moins un via conducteur supplémentaire (212) par la mise en oeuvre des étapes suivantes :
- réalisation d'au moins un trou supplémentaire (203) à travers le substrat (102),
- réalisation, dans ledit trou supplémentaire (203), d'au moins une portion de matériau électriquement conducteur (210) s'étendant dans ledit trou supplémentaire (203) à travers le substrat (102) telle qu'au moins un espace vide (214) restant dudit trou supplémentaire (203) s'étendant à travers le substrat (102) est apte à former une zone de circulation d'un fluide.

13. Procédé d'encapsulation selon l'une des revendications 1 à 10, dans lequel la portion de matériau électriquement conducteur (122, 140) du premier via conducteur (113) est telle qu'au moins un espace vide (214) restant du premier trou (112) s'étendant à travers le substrat (102) est apte à former une zone de circulation d'un fluide.

14. Procédé d'encapsulation selon l'une des revendications 12 ou 13, dans lequel la réalisation de la portion de matériau électriquement conducteur (122) du premier via conducteur (113) et/ou de la portion de matériau électriquement conducteur (210) du via conducteur supplémentaire (212) comporte la mise en oeuvre d'un dépôt d'une couche du matériau électriquement conducteur (122, 210) contre au moins une partie des parois latérales du premier trou (112) et/ou du trou supplémentaire (203).

15. Procédé d'encapsulation selon la revendication 14, comportant en outre, préalablement au dépôt de la couche de matériau électriquement conducteur (122, 210), une étape de dépôt d'une première couche de matériau diélectrique (120, 208) contre les parois latérales du premier trou (112) et/ou du trou supplémentaire (203), ladite couche de matériau électriquement conducteur (122, 210) étant déposée contre la première couche de matériau diélectrique (120, 208), et/ou comportant en outre une étape de dépôt d'une seconde couche de matériau diélectrique (124, 213) contre la couche de matériau électriquement conducteur (122, 210).

16. Procédé de réalisation d'un dispositif électronique (300, 400, 500), comportant au moins la mise en oeuvre d'un procédé d'encapsulation d'un microcomposant selon l'une des revendications 12 à 15, et une solidarisation du substrat (102) sur un support (302).

17. Procédé de réalisation selon la revendication 16, comportant en outre la réalisation d'au moins un canal de circulation de fluide (406) dans le support (302) et le couplage dudit canal de circulation de fluide (406) avec au moins une zone de circulation d'un fluide formée à travers le substrat (102).

18. Procédé de réalisation selon l'une des revendications 16 ou 17, comportant en outre la superposition d'une pluralité de composants électroniques (301) dont la réalisation comporte au moins la mise en oeuvre d'un procédé d'encapsulation d'un microcomposant selon l'une des revendications 12 à 15, les uns sur autres, et le couplage des zones de circulation de fluide desdits dispositifs électroniques (301) les unes aux autres.

## Patentansprüche

1. Verfahren zum Einkapseln wenigstens einer Mikrokomponente (100), die auf einer ersten Fläche (101) eines Substrats (102) und/oder in dem Substrat (102) angeordnet ist, umfassend wenigstens die folgenden Schritte:
a) realisieren wenigstens eines elektrischen Kontaktpunkts (104) auf der ersten Fläche (101) des Substrats (102),
b) realisieren wenigstens eines Bereichs (108) aus Opfermaterial, der wenigstens die Mikrokomponente (100) und wenigstens einen Teil des elektrischen Kontaktpunkts (104) bedeckt,
c) realisieren wenigstens einer dicken Einkapselungsschicht (110, 138, 162), die den Bereich (108) aus Opfermaterial und wenigstens einen Teil der ersten Fläche (101) des Substrats (102) bedeckt,
d) realisieren, durch eine zur ersten Fläche (101) entgegengesetzte zweite Fläche (114) des Substrats (102) hindurch, wenigstens eines ersten Lochs (112), das wenigstens teilweise mit dem elektrischen Kontaktpunkt (104) ausgerichtet ist und auf Höhe des Bereichs (108) aus Opfermaterial mündet,
e) entfernen des Bereichs (108) aus Opfermaterial durch das erste Loch (112) hindurch,
f) realisieren, wenigstens in dem ersten Loch (112), wenigstens eines Bereichs aus elektrisch leitendem Material (122, 140) der elektrisch mit dem elektrischen Kontaktpunkt (104) verbunden ist zum Bilden eines ersten leitenden Durchgangs (113).

2. Verfahren zum Einkapseln nach Anspruch 1, bei dem der elektrische Kontaktpunkt (104) wenigstens einen Bereich (154) aus elektrisch leitendem Material umfasst, der wenigstens einen Hohlraum (156) umgibt, wobei das erste Loch (112) mit dem Hohlraum (156) ausgerichtet ist.

3. Verfahren zum Einkapseln nach Anspruch 2, bei dem der Bereich (154) aus elektrisch leitendem Material in einer Ebene parallel zur ersten Fläche (101) des Substrats (102) eine Ringform hat.

4. Verfahren zum Einkapseln nach einem der vorhergehenden Ansprüche, bei dem der Schritt c) durch Aufbringen eines Harzes vom Polymertyp erzielt wird, das die dicke Einkapselungsschicht (110, 138) bildet.

5. Verfahren zum Einkapseln nach einem der Ansprüche 1 bis 3, bei dem der Schritt c) erzielt wird durch:
- durchschneiden eines Bereichs (159) des Substrats (102), an dem die Mikrokomponente (100) der elektrische Kontaktpunkt (104) und der Bereich (108) aus Opfermaterial angeordnet sind, und anschließend
- anordnen des Bereichs (159) des Substrats (102), der Mikrokomponente (100) des elektrischen Kontaktpunkts (104) und des Bereichs (108) aus Opfermaterial an einer Stelle, die in wenigstens einem zweiten Substrat (162) gebildet ist, das die dicke Einkapselungsschicht bildet.

6. Verfahren zum Einkapseln nach einem der vorhergehenden Ansprüche, ferner umfassend die Durchführung einer Abdünnung des Substrats (102) auf Höhe seiner zweiten Fläche (114) nach dem Schritt c).

7. Verfahren zum Einkapseln nach einem der vorhergehenden Ansprüche, ferner umfassend das Durchführen eines Schritts des Verbindens der dicken Einkapselungsschicht (110, 138) mit wenigstens einem zweiten Substrat (128) nach dem Schritt c).

8. Verfahren zum Einkapseln nach einem der vorhergehenden Ansprüche, ferner umfassend das Durchführen, zwischen den Schritten b) und c), eines Schritts des Aufbringens wenigstens einer Zwischenschicht (132, 134) auf Basis wenigstens eines dielektrischen mineralischen Materials und/oder wenigstens eines elektrisch leitenden Materials, die den Bereich (108) aus Opfermaterial bedeckt, wobei die dicke Einkapselungsschicht (110, 138, 162) wenigstens die Zwischenschicht (132, 134) bedeckt.

9. Verfahren zum Einkapseln nach Anspruch 8, bei dem dann, wenn der Bereich (108) aus Opfermaterial durch die Zwischenschicht (134) auf Basis des elektrisch leitenden Materials bedeckt ist, wenigstens ein Bereich aus elektrisch leitendem Material (122) auf der zweiten Fläche (114) des Substrats (104) angeordnet ist und elektrisch mit der Zwischenschicht (134) verbunden ist mittels wenigstens eines zweiten Lochs (136), das durch die zweite Fläche (114) des Substrats (102) hindurch realisiert ist und auf Höhe der Zwischenschicht (134) mündet.

10. Verfahren zum Einkapseln nach einem der vorhergehenden Ansprüche, ferner umfassend das Durchführen, vor dem Schritt c), eines Schritts des Realisierens von Schneidwegen (106) in dem Substrat (102), und nach dem Schritt c) eines Schritts des Schneidens des Substrats (102) entlang der Schneidwege (106).

11. Verfahren zum Einkapseln nach einem der vorhergehenden Ansprüche, ferner umfassend, wenn der Bereich aus elektrisch leitendem Material (122, 140), der elektrisch mit dem elektrischen Kontaktpunkt (104) verbunden ist, das erste Loch (112) nicht verschließt, ein Aufbringen eines dielektrischen Materials auf und/oder in dem ersten Loch (112) zum Verschließen des ersten Lochs (112).

12. Verfahren zum Einkapseln nach einem der vorhergehenden Ansprüche, ferner umfassend das Realisieren wenigstens eines zusätzlichen leitenden Durchgangs (212) mittels Durchführung der folgenden Schritte:
- realisieren wenigstens eines zusätzlichen Lochs (203) durch das Substrat (102) hindurch,
- realisieren, in dem zusätzlichen Loch (203), wenigstens eines Bereichs aus elektrisch leitendem Material (210) der sich durch das Substrat (102) hindurch derart in das zusätzliche Loch (203) hinein erstreckt, dass wenigstens ein Hohlraum (214), der bei dem zusätzlichen Loch (203) verbleibt und sich durch das Substrat (102) hindurch erstreckt, dazu geeignet ist, eine Fluidzirkulationszone zu bilden.

13. Verfahren zum Einkapseln nach einem der Ansprüche 1 bis 10, bei dem der Bereich aus elektrisch leitendem Material (122, 140) des ersten leitenden Durchgangs (113) derart ist, dass wenigstens ein Hohlraum (214), der bei dem ersten Loch (112) verbleibt und sich durch das Substrat (102) hindurch erstreckt, dazu geeignet ist, eine Fluidzirkulationszone zu bilden.

14. Verfahren zum Einkapseln nach einem der Ansprüche 12 oder 13, bei dem das Realisieren des Bereichs aus elektrisch leitendem Material (122) des ersten leitenden Durchgangs (113) und/oder des Bereichs aus elektrisch leitendem Material (210) des zusätzlichen leitenden Durchgangs (212) die Durchführung einer Aufbringung einer Schicht aus elektrisch leitendem Material (122, 210) auf wenigstens einem Teil der Seitenwände des ersten Lochs (112) und/oder des zusätzlichen Lochs (203) umfasst.

15. Verfahren zum Einkapseln nach Anspruch 14, ferner umfassend, vor dem Aufbringen der Schicht aus elektrisch leitendem Material (122, 210), einen Schritt des Aufbringens einer ersten Schicht aus dielektrischem Material (120, 208) auf den Seitenwänden des ersten Lochs (112) und/oder des zusätzlichen Lochs (203), wobei die Schicht aus elektrisch leitendem Material (122, 210) auf der ersten Schicht aus dielektrischem Material (120, 208) aufgebracht wird, und/oder ferner umfassend einen Schritt des Aufbringens einer zweiten Schicht aus dielektrischem Material (124, 213) auf der Schicht aus elektrisch leitendem Material (122, 210).

16. Verfahren zum Realisieren einer elektronischen Vorrichtung (300, 400, 500), umfassend wenigstens die Durchführung eines Verfahrens zum Einkapseln einer Mikrokomponente nach einem der Ansprüche 12 bis 15, sowie ein Verbinden des Substrats (102) auf einem Träger (302).

17. Verfahren zur Realisierung nach Anspruch 16, ferner umfassend die Realisierung wenigstens eines Fluidzirkulationskanals (406) in dem Träger (302) und die Kopplung des Fluidzirkulationskanals (406) mit wenigstens einer Fluidzirkulationszone, die durch das Substrat (102) hindurch gebildet ist.

18. Verfahren zum Realisieren nach einem der Ansprüche 16 oder 17, ferner umfassend die Überlagerung einer Mehrzahl von elektronischen Komponenten (301), deren Realisierung wenigstens die Durchführung eines Verfahrens zum Einkapseln einer Mikrokomponente nach einem der Ansprüche 12 bis 15 umfasst, aufeinander, sowie die Kopplung der Fluidzirkulationszonen der elektronischen Vorrichtungen (301) aneinander.

## Claims

1. A method of encapsulating at least one microcomponent (100) positioned on a first face (101) of a substrate (102) and/or in the substrate (102), including at least the following steps:
a) production of at least one electrical contact pad (104) on the first face (101) of the substrate (102),
b) production of at least one portion (108) of sacrificial material covering at least the microcomponent (100) and at least a part of the electrical contact pad (104),
c) production of at least one thick encapsulation layer (110, 138, 162) covering the portion (108) of sacrificial material, and at least a part of the first face (101) of the substrate (102),
d) production, through a second face (114), opposite the first face (101), of the substrate (102), of at least one first hole (112) aligned at least partially with the electrical contact pad (104), and emerging at the portion (108) of sacrificial material,
e) elimination of the portion (108) of sacrificial material through the first hole (112),
f) production, at least in the first hole (112), of at least one portion of electrically conductive material (122, 140) electrically connected to the electrical contact pad (104), forming a first conductive via (113).

2. An encapsulation method according to claim 1, in which the electrical contact pad (104) includes at least one portion (154) of electrically conductive material surrounding at least one empty space (156), where the first hole (112) is aligned with the empty space (156).

3. An encapsulation method according to claim 2, in which the portion (154) of electrically conductive material is shaped, in a plane parallel to the first face (101) of the substrate (102), like a ring.

4. An encapsulation method according to one of the previous claims, in which step c) is obtained by deposition of a resin of a polymer type forming the thick encapsulation layer (110, 138).

5. An encapsulation method according to one of claims 1 to 3, in which step c) is obtained:
- by cutting a portion (159) of the substrate (102) against which the microcomponent (100), the electrical contact pad (104) and the portion (108) of sacrificial material are positioned, followed by
- positioning said portion (159) of the substrate (102), the microcomponent (100), the electrical contact pad (104) and the portion (108) of sacrificial material in a slot formed in at least one second substrate (162) forming the thick encapsulation layer.

6. An encapsulation method according to one of the previous claims, also including thinning, after step c), of the substrate (102) at its second face (114).

7. An encapsulation method according to one of the previous claims, also including implementation, after step c), of a step of secure attachment of the thick encapsulation layer (110, 138) to at least one second substrate (128).

8. An encapsulation method according to one of the previous claims, also including implementation, between steps b) and c), of a step of deposition of at least one intermediate layer (132, 134) made from at least one dielectric mineral material and/or at least one electrically conductive material covering the portion (108) of sacrificial material, where the thick encapsulation layer (110, 138, 162) covers at least the intermediate layer (132, 134).

9. An encapsulation method according to claim 8, in which, when the portion (108) of sacrificial material is covered by the intermediate layer (134) made of electrically conductive material, at least one portion of electrically conductive material (122) is positioned on the second face (114) of the substrate (104) and connected electrically to the intermediate layer (134) through at least one second hole made through the second face (114) of the substrate (102), and emerging at the intermediate layer (134).

10. An encapsulation method according to one of the previous claims, also including the implementation, before step c), of a step of production of scribe lines (106) in the substrate (102), and, after step c), of a step of cutting the substrate (102) along the scribe lines (106).

11. An encapsulation method according to one of the previous claims, also including, when the portion of electrically conductive material (122, 140) electrically connected to the electrical contact pad (104) does not plug the first hole (112), a deposition on and/or in the first hole (112) of a dielectric material plugging the first hole (112).

12. An encapsulation method according to one of the previous claims, also including making at least one additional conductive via (212) by implementing the following steps:
- making at least one additional hole (203) through the substrate (102),
- production, in said additional hole (203), of at least one portion of electrically conductive material (210) extending in said additional hole (203) through the substrate (102), such that at least one remaining empty space (214) of said additional hole (203) extending through the substrate (102) is able to form a zone in which a fluid can flow.

13. An encapsulation method according to one of claims 1 to 10, in which the portion of electrically conductive material (122, 140) of the first conductive via (113) is such that at least one remaining empty space (214) of the first hole (112) extending through the substrate (102) is able to form a zone in which a fluid may flow.

14. An encapsulation method according to either of claims 12 or 13, in which production of the portion of electrically conductive material (122) of the first conductive via (113) and/or of the portion of electrically conductive material (210) of the additional conductive via (212) includes deposition of a layer of electrically conductive material (122, 210) against at least a part of the side walls of the first hole (112) and/or of the additional hole (203).

15. An encapsulation method according to claim 14, also including, prior to the deposition of the layer of electrically conductive material (122, 210), a step of deposition of a first layer of dielectric material (120, 208) against the side walls of the first hole (112) and/or of the additional hole (203), where said layer of electrically conductive material (122, 210) is deposited against the first layer of dielectric material (120, 208), and/or also including a step of deposition of a second layer of dielectric material (124, 213) against the layer of electrically conductive material (122, 210).

16. A method of production of an electronic device (300, 400, 500), including a least the implementation of a method of encapsulating a microcomponent according to one of claims 12 to 15, and secure attachment of the substrate (102) on a support (302).

17. A method of production according to claim 16, also including the production of at least one fluid flow channel (406) in the support (302), and the coupling of said fluid flow channel (406) with at least one fluid flow zone formed through the substrate (102).

18. A method of production according to either of claims 16 or 17, also including the superposition of multiple electronic components (301) the production of which includes at least the implementation of one method of encapsulating a microcomponent according to one of claims 12 to 15, one on top of another, and the coupling of the fluid flow zones of said electronic components (301) to one another.
